# EUROPEAN PATENT APPLICATION

(11) **EP 4 651 681 A1**
(43) Date of publication of application: **19.11.2025**
(21) Application number: 25172879.6
(22) Date of filing: 28.04.2025
(51) Int. Cl.: H10H 20/813, H10H 20/83, H10H 29/30

(54) **LIGHT EMITTING DIODE, DISPLAY DEVICE INCLUDING LIGHT EMITTING DIODE AND ELECTRONIC DEVICE INCLUDING DISPLAY DEVICE**

(30) Priority: 13.05.2024 KR 20240062507
(71) Applicant: Samsung Display Co., Ltd., Gyeonggi-Do (KR)
(72) Inventor: YOO, Chul Jong, Yongin-si (KR); KANG, Jong Hyuk, Yongin-si (KR); KIM, Sang-Jo, Yongin-si (KR); PARK, Jin-Taek, Yongin-si (KR); JEONG, Junseok, Yongin-si (KR); CHA, Hyungrae, Yongin-si (KR)
(74) Representative: Marks & Clerk LLP

(57) **Abstract**

Disclosed is a light emitting diode which includes a first electrode layer including a reflective material, a semiconductor layer disposed on the first electrode layer and including a plurality of light emitting members spaced apart from each other, a second electrode layer including a plurality of sub-electrodes disposed on the plurality of light emitting members, respectively, and a protective layer covering the semiconductor layer. The semiconductor layer includes a first semiconductor layer including a base semiconductor layer disposed on the first electrode layer and a plurality of sub-semiconductor layers protruding from the base semiconductor layer, a plurality of active layers disposed on the plurality of sub-semiconductor layers, respectively, and a plurality of active layers disposed on the plurality of sub-semiconductor layers, respectively. The plurality of sub-electrodes are disposed on the plurality of second semiconductor layers, respectively.

## Description

### BACKGROUND

Embodiments described herein relate to a light emitting diode including a semiconductor layer, a display device including the light emitting diode, and an electronic device including the display device.

Electronic devices, such as a smart phone, a notebook computer, a car navigation unit, a smart television, and the like, which provide an image to a user include a display device for displaying an image. For example, an augmented reality (AR) device, a virtual reality (VR) device, a video projection device, or the like may include a micro display device. To display a high-brightness image while operating at low power, the micro display device may include a complementary metal oxide semiconductor (CMOS) wafer and light emitting diodes disposed on the CMOS wafer. Studies have been increasingly conducted to improve the display quality of a display device including light emitting diodes.

### SUMMARY

Embodiments provide a light emitting diode having excellent light efficiency and a manufacturing method of the light emitting diode.

Embodiments provide a display device including a light emitting diode having excellent display quality and an electronic device including the display device.

However, embodiments are not limited to those set forth herein. The above and other embodiments will become more apparent to one of ordinary skill in the art to which the disclosure pertains by referencing the detailed description of the disclosure given below.

According to an embodiment, a light emitting diode includes a first electrode layer including a reflective material, a semiconductor layer disposed on the first electrode layer and including a plurality of light emitting members spaced apart from each other, a second electrode layer including a plurality of sub-electrodes disposed on the plurality of light emitting members, respectively, and a protective layer covering the semiconductor layer. The semiconductor layer includes a first semiconductor layer including a base semiconductor layer disposed on the first electrode layer and a plurality of sub-semiconductor layers protruding from the base semiconductor layer, a plurality of active layers disposed on the plurality of sub-semiconductor layers, respectively, and a plurality of second semiconductor layers disposed on the plurality of active layers, respectively. The plurality of sub-electrodes are disposed on the plurality of second semiconductor layers, respectively.

The base semiconductor layer may be directly disposed on the first electrode layer, and wherein the base semiconductor layer and the plurality of sub-semiconductor layers may have a single body shape.

The first semiconductor layer may be an N-type semiconductor layer, and each of the plurality of second semiconductor layers may be a P-type semiconductor layer.

Each of the first semiconductor layer and the second semiconductor layers may include at least one of gallium nitride (GaN), indium gallium nitride (InGaN), and aluminium gallium nitride (AlGaN).

The light emitting diode may further include: an optical control layer disposed between the first electrode layer and the base semiconductor layer.

The optical control layer may include a reflective material or a transparent conductive material.

The protective layer may include: a first insulating layer disposed on sidewalls of the plurality of light emitting members and an upper surface of the base semiconductor layer disposed between the plurality of light emitting members; and a second insulating layer disposed on the first insulating layer.

The second insulating layer may fill separation spaces between the plurality of light emitting members.

The protective layer may include a plurality of openings exposing the plurality of sub-electrodes.

The reflective material may include at least one of silver (Ag), aluminium (Al), gold (Au), chromium (Cr), a distributed Bragg reflective material, and barium sulfate (BaSO₄).

According to an embodiment, a display device includes a base layer, a circuit element layer disposed on the base layer, and a light emitting element layer disposed on the circuit element layer and including light emitting diode. The light emitting diode includes a first electrode layer including a reflective material, a semiconductor layer disposed on the first electrode layer and including a plurality of light emitting members spaced apart from each other, a second electrode layer including a plurality of sub-electrodes disposed on the plurality of light emitting members, respectively, and a protective layer covering the semiconductor layer. The semiconductor layer includes a first semiconductor layer including a base semiconductor layer disposed on the first electrode layer and a plurality of sub-semiconductor layers protruding from the base semiconductor layer, a plurality of active layers disposed on the plurality of sub-semiconductor layers, respectively, and a plurality of second semiconductor layers disposed on the plurality of active layers, respectively. The light emitting element layer includes a cathode connecting electrode connected to the first electrode layer and an anode connecting electrode connected to the second electrode layer.

The light emitting element layer may include: a via layer disposed on the circuit element layer, the via layer having first and second via holes exposing the anode connecting electrode and the cathode connecting electrode; and a bridge electrode electrically connected to the anode connecting electrode through the first via hole, the bridge electrode electrically connecting the anode connecting electrode and the second electrode layer, and the cathode connecting electrode may be electrically connected to the first electrode layer through the second via hole.

The light emitting element layer may further include a bonding electrode electrically connected to the cathode connecting electrode through the second via hole, and the first electrode layer may be disposed on the bonding electrode and electrically connected to the cathode connecting electrode through the bonding electrode.

The light emitting element layer may include: a bank layer having a light emitting opening exposing the light emitting diode; a flattening layer disposed in the light emitting opening to cover the light emitting diode; and an overcoating layer disposed on the bank layer and the flattening layer.

The light emitting element layer may include: a bank layer having a light emitting opening exposing the light emitting diode; a color conversion layer disposed in the light emitting opening to convert a color of light output from the light emitting diode; and an overcoating layer covering the bank layer and the color conversion layer.

The display device may further include: a color filter layer disposed on the light emitting element layer, the color filter layer including a color filter.

The base semiconductor layer may be directly disposed on the first electrode layer, and the base semiconductor layer and the plurality of sub-semiconductor layers may have a single body shape.

The first semiconductor layer may be an N-type semiconductor layer, and each of the plurality of second semiconductor layers may be a P-type semiconductor layer.

The display device may further include: an optical control layer disposed between the first electrode layer and the base semiconductor layer, wherein the optical control layer may include a reflective material or a transparent conductive material.

The protective layer may include: a first insulating layer disposed on sidewalls of the plurality of light emitting members and an upper surface of the base semiconductor layer disposed between the plurality of light emitting members; and a second insulating layer disposed on the first insulating layer.

According to an embodiment, an electronic device includes: a display device; and a frame accommodating the display device, wherein the display device includes: a base layer; a circuit element layer disposed on the base layer; and a light emitting element layer disposed on the circuit element layer, the light emitting element layer including a light emitting diode, the light emitting diode includes: a first electrode layer including a reflective material; a semiconductor layer disposed on the first electrode layer, the semiconductor layer including a plurality of light emitting members spaced apart from each other; a second electrode layer including a plurality of sub-electrodes disposed on the plurality of light emitting members, respectively; and a protective layer covering the semiconductor layer, the semiconductor layer includes: a first semiconductor layer including a base semiconductor layer disposed on the first electrode layer and a plurality of sub-semiconductor layers protruding from the base semiconductor layer; a plurality of active layers disposed on the plurality of sub-semiconductor layers, respectively; and a plurality of second semiconductor layers disposed on the plurality of active layers, respectively, and the light emitting element layer includes a cathode connecting electrode electrically connected to the first electrode layer and an anode connecting electrode electrically connected to the second electrode layer.

At least some of the above and other features of the invention are set out in the claims.

### BRIEF DESCRIPTION OF THE DRAWINGS

The above and other objects and features of the disclosure will become apparent by describing in detail embodiments thereof with reference to the accompanying drawings.
FIG. 1 is a schematic perspective view illustrating a display device according to an embodiment.
FIG. 2 is a schematic cross-sectional view illustrating the display device according to an embodiment.
FIG. 3 is a schematic plan view illustrating the display device according to an embodiment.
FIG. 4A is an enlarged schematic plan view of area AA' of FIG. 3 according to an embodiment.
FIG. 4B is a perspective view of a light emitting diode illustrated in FIG. 4A.
FIG. 5A is an enlarged plan view of area AA' of FIG. 3 according to an embodiment.
FIG. 5B is a schematic perspective view of a light emitting diode illustrated in FIG. 5A.
FIGS. 6A and 6B are schematic cross-sectional views of the light emitting diode taken along line I-I' of FIG. 4A according to embodiments.
FIGS. 7A and 7B are schematic cross-sectional views of light emitting diodes according to embodiments.
FIGS. 8A and 8B are schematic cross-sectional views of light emitting diodes according to embodiments.
FIGS. 9A to 9H are process views illustrating a process of manufacturing a light emitting diode according to an embodiment.
FIGS. 10A to 10H are process views illustrating a process of manufacturing a light emitting diode according to an embodiment.
FIGS. 11A to 11J are process views illustrating a manufacturing process of a light emitting diode according to an embodiment.
FIG. 12A is a schematic plan view illustrating an arrangement structure of red, green, and blue light emitting diodes according to an embodiment.
FIG. 12B is a schematic plan view illustrating an arrangement structure of red, first green, blue, and second green light emitting diodes according to an embodiment.
FIG. 13A is a schematic cross-sectional view illustrating the display device according to an embodiment.
FIG. 13B is a schematic cross-sectional view illustrating the display device according to an embodiment.
FIG. 14A is a schematic view illustrating a smart watch employing a display device according to an embodiment.
FIG. 14B is a schematic view illustrating a glasses-type virtual reality device employing a display device according to an embodiment.

### DETAILED DESCRIPTION OF THE EMBODIMENTS

In the following description, for the purposes of explanation, numerous specific details are set forth in order to provide a thorough understanding of various embodiments or implementations of the invention. As used herein, "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element or a layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the axis of the first direction DR1, the axis of the second direction DR2, and the axis of the third direction DR3 are not limited to three axes of a rectangular coordinate system, such as the X, Y, and Z - axes, and may be interpreted in a broader sense. For example, the axis of the first direction DR1, the axis of the second direction DR2, and the axis of the third direction DR3 may be perpendicular to one another, or may represent different directions that are not perpendicular to one another. For the purposes of this disclosure, "at least one of A and B" may be understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate members. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

Hereinafter, embodiments will be described with reference to the accompanying drawings.

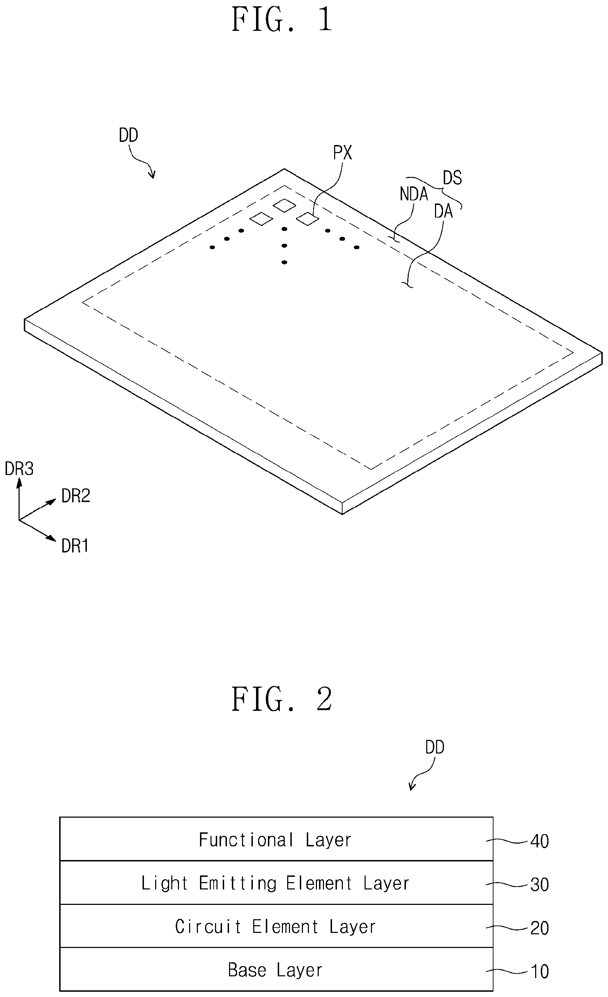

FIG. 1 is a schematic perspective view of a display device DD according to an embodiment.

Referring to FIG. 1, the display device DD may have a rectangular shape including long sides parallel to a first direction DR1 and short sides parallel to a second direction DR2 intersecting the first direction DR1. However, embodiments are not limited thereto, and the display device DD may have various shapes such as a circular shape or a polygonal shape. Hereinafter, a direction substantially perpendicular to a plane defined by the first direction DR1 and the second direction DR2 is defined as a third direction DR3. The expression "when viewed from above the plane" or "in plan view" used herein may mean that it is viewed in the third direction DR3.

The display device DD according to an embodiment may be a device activated according to an electrical signal. The display device DD may be employed (or implemented) in a television, a monitor, a billboard, a tablet computer, a car navigation unit, a personal computer, a notebook computer, a personal digital terminal, a game machine, a smart phone, a camera, and a wearable device. For example, the wearable device may include a virtual reality device, an augmented reality device, and a smart watch. The virtual reality device and the augmented reality device may be devices in the form of eyeglasses that are able to be worn by a user. These devices are provided only as examples, and the display device DD may be employed (or implemented) in other devices as long as it does not depart from the spirit and scope of the disclosure.

The display device DD may display a video (or an image) through a display surface DS. The display surface DS may be parallel to the plane defined by the first direction DR1 and the second direction DR2.

The display surface DS may include a display area DA and a non-display area NDA adjacent to the display area DA. The display device DD may display an image through the display area DA. The non-display area NDA may surround the display area DA. In another example, the non-display area NDA may be disposed adjacent to a side (e.g., single side) of the display area DA, or may be omitted.

Pixels PX may be disposed in the display area DA. The pixels PX may be arranged in a matrix form. Each of the pixels PX may include a pixel circuit and a light emitting diode. The pixels PX may all generate light of the same color. In another example, pixels PX that generate light of different colors may be disposed in the display area DA. For example, first pixels that output light of a first color (or red light), second pixels that output light of a second color (or green light), and third pixels that output light of a third color (or blue light) may be disposed in the display area DA.

FIG. 2 is a schematic cross-sectional view illustrating the display device DD according to an embodiment.

Referring to FIG. 2, the display device DD may include a base layer 10, a circuit element layer 20, and a light emitting element layer 30. The display device DD may further include a functional layer 40 disposed on the light emitting element layer 30.

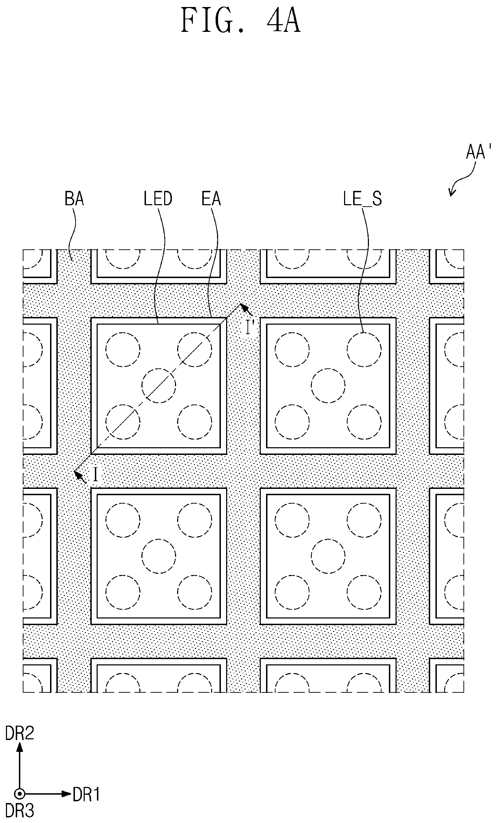

The base layer 10 may include a silicon substrate. The circuit element layer 20 may be disposed on the base layer 10 and may include a pixel circuit. The pixel circuit may control an operation of a light emitting diode LED (refer to FIG. 4A) of the light emitting element layer 30 that will be described below. The pixel circuit may include at least one transistor. Pixel areas may be defined in the base layer 10, and pixel circuits may be disposed in the pixel areas, respectively.

The light emitting element layer 30 may include the light emitting diode LED electrically connected to the pixel circuit. The light emitting diode LED may be a type of compound semiconductor. The light emitting diode LED may be an electrically driven light emitting diode including gallium (Ga), phosphorus (P), and arsenic (As) as main semiconductor materials. When a forward current is applied to a p-n junction structure, electrons and holes may be recombined with each other at the interface to generate light of a specific wavelength that corresponds to energy band gap. The light emitting diode LED will be described below in more detail.

The functional layer 40 may include an anti-reflective layer or a lens layer. The anti-reflective layer may decrease the reflectance of external light incident from the outside. In an embodiment, the anti-reflective layer may include a color filter layer. In another example, the anti-reflective layer may include a phase retarder and a polarizer.

The lens layer may include a lens disposed to correspond to (or overlapping) the light emitting diode LED. The lens may condense light output from the light emitting diode LED. For example, the lens may include various types of lenses such as a multi-channel lens, a convex lens, a concave lens, a spherical lens, an aspheric lens, a single lens, a compound lens, a normal lens, a narrow-angle lens, a wide-angle lens, a fixed focus lens, a variable focus lens, and the like.

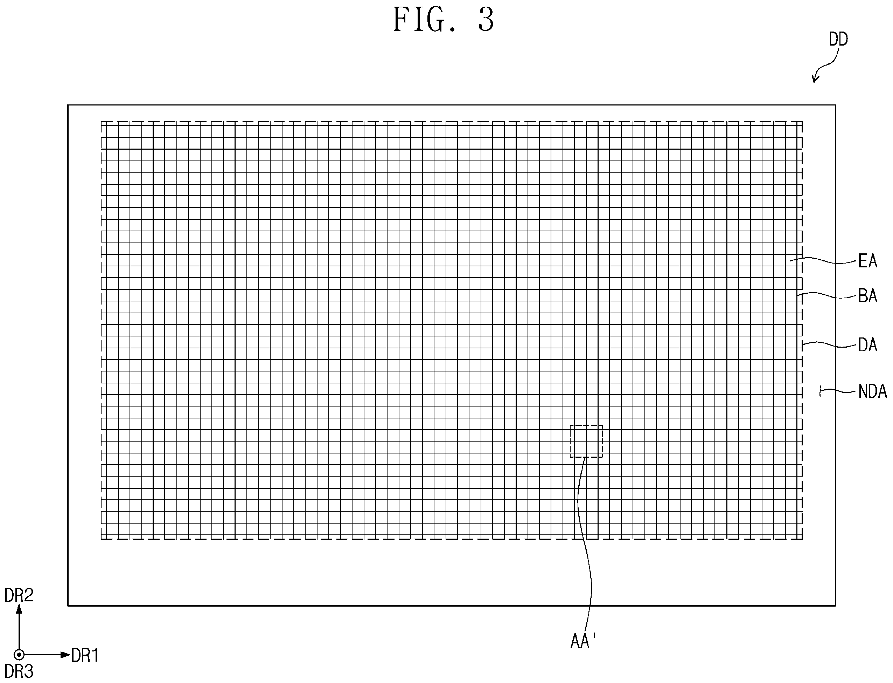

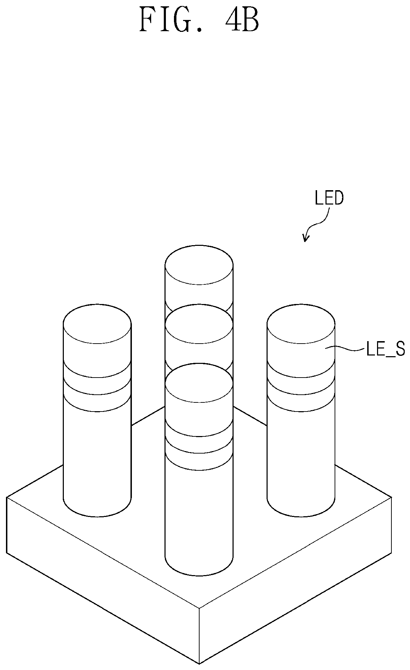

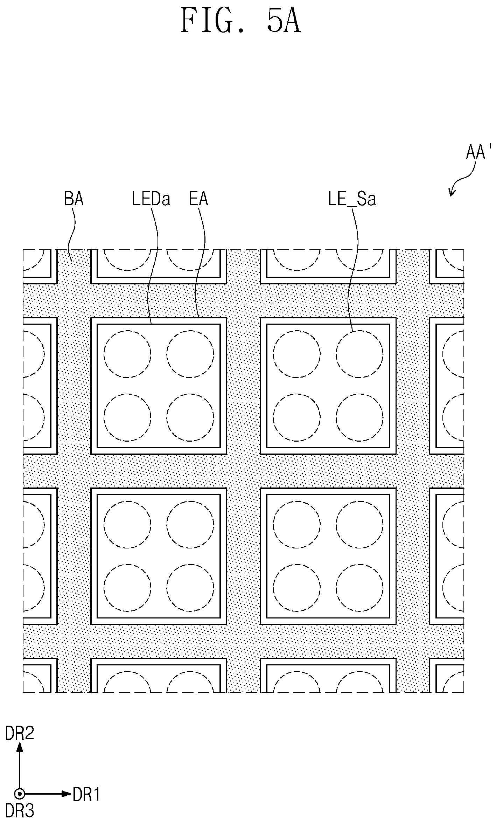

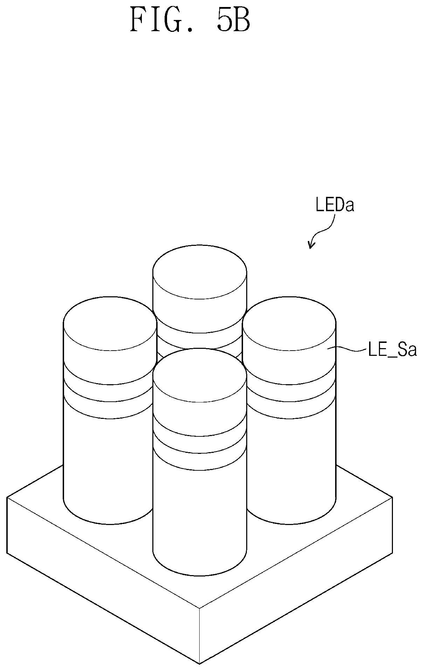

FIG. 3 is a schematic plan view illustrating the display device DD according to an embodiment. FIG. 4A is an enlarged schematic plan view of area AA' of FIG. 3 according to an embodiment, and FIG. 4B is a schematic perspective view of the light emitting diode LED illustrated in FIG. 4A. FIG. 5A is an enlarged schematic plan view of area AA' of FIG. 3 according to an embodiment, and FIG. 5B is a perspective view of a light emitting diode LEDa illustrated in FIG. 5A.

Referring to FIGS. 3, 4A, and 4B, the display device DD may include a display area DA and a non-display area NDA adjacent to the display area DA. The display area DA may include light emitting areas EA and a non-light emitting area BA.

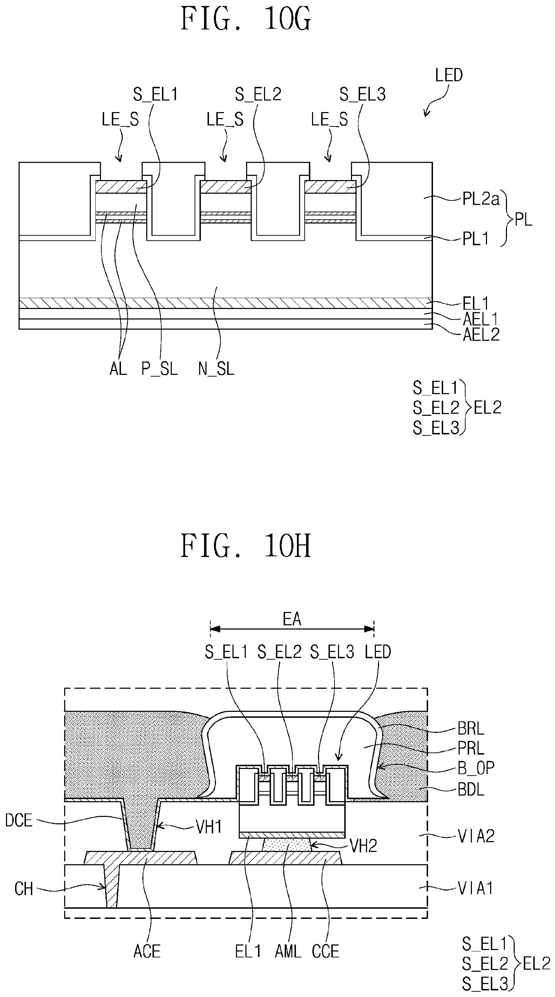

The light emitting areas EA may be areas where light emitting diodes LED are disposed, respectively. The light emitting areas EA may be areas through which light generated by the light emitting diodes LED is output. The non-light emitting area BA may be an area where a bank layer BDL (refer to FIG. 10H) defining (or dividing) the light emitting areas EA is disposed. In an embodiment, the bank layer BDL may include a light blocking material. Accordingly, the non-light emitting area BA may be a light blocking area that blocks light and may be a boundary area that defines the boundaries between the light emitting areas EA.

In an embodiment, the light emitting areas EA may include first light emitting areas through which the light of the first color (or red light) is output, second light emitting areas through which the light of the second color (or green light) is output, and third light emitting areas through which the light of the third color (or blue light) is output.

A light emitting diode (e.g., single light emitting diode) LED may be disposed in each of the light emitting areas EA. The light emitting diode LED may have a size ranging from nanometer scale to micrometer scale. The light emitting diode LED may have a diameter (or a width) and/or a length ranging from nanometer scale to micrometer scale. In an embodiment, the light emitting diode LED may have a diameter (or a width) and/or a length of about 5 µm or less. However, without being limited thereto, the size of the light emitting diode LED may be changed in various ways according to the design condition of the display device that employs (or forms) the light emitting diode LED.

The light emitting diode LED may generate one of the light of the first color, the light of the second color, and the light of the third color. The light emitting diode LED may include light emitting members (or light emitting structures) LE_S. The light emitting members LE_S may output light of the same color. In an embodiment, the light emitting members LE_S may be spaced apart from one another. The light emitting members LE_S may have a circular shape or a polygonal shape (e.g., a quadrangular shape, a hexagonal shape, or an octagonal shape) when viewed from above the plane. As illustrated in FIG. 4B, the light emitting members LE_S may have a cylindrical shape. However, embodiments are not limited thereto, and the light emitting members LE_S may have a polygonal prism shape (e.g., a rectangular prism shape, a hexagonal prism shape, or an octagonal prism shape).

Although FIGS. 4A and 4B illustrate the structure in which the light emitting diode LED includes five light emitting members LE_S, embodiments are not limited thereto. As illustrated in FIGS. 5A and 5B, the light emitting diode LEDa may include four light emitting members LE_Sa. As illustrated in FIG. 5B, the light emitting members LE_Sa may have a cylindrical shape. However, embodiments are not limited thereto, and the light emitting members LE Sa may have a polygonal prism shape.

The numbers of light emitting members LE_S and LE_Sa included in the light emitting diodes LED and LEDa are not limited to the embodiments illustrated in FIGS. 4A to 5B and may be modified in various ways. The light emitting members LE_S and LE_Sa may have a diameter ranging from nanometer scale to micrometer scale. In an embodiment, each of the light emitting members LE_S and LE_Sa may have a diameter of about 1.5 µm or less.

In the case that the light emitting diodes LED and LEDa include the light emitting members LE_S and LE_Sa as described above, the densities of driving currents for driving the light emitting diodes LED and LEDa may be increased. Thus, the driving performance of the light emitting diodes LED and LEDa may be improved without an increase in voltage.

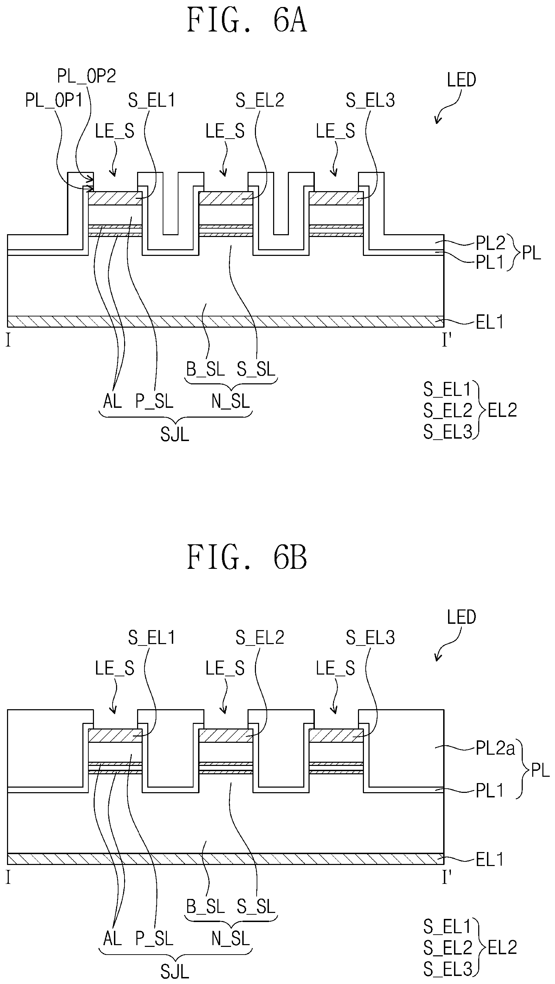

FIGS. 6A and 6B are schematic cross-sectional views of the light emitting diode taken along line I-I' of FIG. 4A according to embodiments.

Referring to FIG. 6A, the light emitting diode LED includes a first electrode layer EL1, a semiconductor layer SJL, a second electrode layer EL2, and a protective layer PL.

The first electrode layer EL1 may include a conductive material. The first electrode layer EL1 may be a cathode electrode of the light emitting diode LED. In an embodiment, the first electrode layer EL1 may include a reflective material (or a high-reflective material) having a relatively high reflectance. For example, the reflective material may include at least one of silver (Ag), aluminium (Al), gold (Au), chromium (Cr), a distributed Bragg reflective material, and barium sulfate (BaSO₄). The first electrode layer EL1 may be referred to as a reflective electrode layer. In the case that the first electrode layer EL1 includes a high-reflective material, light generated by the semiconductor layer SJL may be reflected by the first electrode layer EL1, and thus the light efficiency of the light emitting diode LED may be increased.

The semiconductor layer SJL is disposed on the first electrode layer EL1 and includes the light emitting members LE_S spaced apart from one another. The semiconductor layer SJL includes a first semiconductor layer N_SL, active layers AL, and second semiconductor layers P_SL.

The first semiconductor layer N_SL may include an N-type semiconductor layer or a P-type semiconductor layer. For example, the N-type semiconductor layer may include at least one semiconductor material among InAlGaN, GaN, AlGaN, InGaN, AlN, and InN and may be doped with a first conductive type dopant such as silicon (Si), germanium (Ge) or tin (Sn). The P-type semiconductor layer may include at least one semiconductor material among InAlGaN, GaN, AlGaN, InGaN, AlN, and InN and may be doped with a second conductive type dopant such as magnesium (Mg), zinc (Zn), calcium (Ca), or barium (Ba). However, this is illustrative, and materials constituting the N-type semiconductor layer and the P-type semiconductor layer are not limited thereto.

The first semiconductor layer N_SL includes a base semiconductor layer B_SL and sub-semiconductor layers S_SL. The base semiconductor layer B_SL is disposed (e.g., directly disposed) on the first electrode layer EL1, and the sub-semiconductor layers S_SL have a structure protruding from the upper surface of the base semiconductor layer B_SL. Each of the sub-semiconductor layers S_SL may have a cylindrical shape or a polygonal prism shape. For example, the sub-semiconductor layers S_SL may be provided on the base semiconductor layer B_SL in a multi-pillar structure. The base semiconductor layer B_SL may have a one-body shape (or single body shape) with the sub-semiconductor layers S_SL. The base semiconductor layer B_SL and the sub-semiconductor layers S_SL may include a semiconductor material of the same type.

The second semiconductor layers P_SL may be disposed to correspond to (or overlapping) the sub-semiconductor layers S_SL, respectively. Each of the second semiconductor layers P_SL may include an N-type semiconductor layer or a P-type semiconductor layer. The second semiconductor layers P_SL may include a semiconductor material of a type different from that of the first semiconductor layer N_SL. For example, in the case that the first semiconductor layer N_SL includes an N-type semiconductor layer, each of the second semiconductor layers P_SL may include a P-type semiconductor layer. In the case that the first semiconductor layer N_SL includes a P-type semiconductor layer, each of the second semiconductor layers P_SL may include an N-type semiconductor layer.

The active layers AL are disposed on the sub-semiconductor layers S_SL, respectively. Each of the active layers AL may be disposed between a corresponding sub-semiconductor layer S_SL and a corresponding second semiconductor layer P_SL. The active layer AL may be formed in a single-quantum well structure or a multi-quantum well structure. The active layer AL may emit light by a recombination of electrons and holes according to an electrical signal applied through the P-type semiconductor layer and the N-type semiconductor layer. The active layer AL may emit light in a wavelength range of about 400 nm to about 900 nm and may use a double hetero-structure.

For example, the active layer AL may have a structure in which a semiconductor material having high energy band gap and semiconductor materials having low energy band gap are alternately stacked with each other. For example, the active layer AL may include Group III to V semiconductor materials selected according to the wavelength band of emitted light. As used herein, the term "Group" means a group of the IUPAC periodic table.

Each of the light emitting members LE_S may be defined by the sub-semiconductor layer S_SL, the active layer AL, and the second semiconductor layer P_SL.

The second electrode layer EL2 includes sub-electrodes S_EL1 to S_EL3 disposed on the light emitting members LE_S, respectively. For example, the sub-electrodes S_EL1 to S_EL3 may be disposed on the upper surfaces of the light emitting members LE_S (e.g., the upper surfaces of the second semiconductor layers P_SL). The second electrode layer EL2 may be an anode electrode of the light emitting diode LED. In an embodiment, the second electrode layer EL2 may include a transparent conductive material. For example, the transparent conductive material may include transparent conductive oxide such as indium tin oxide (ITO), indium zinc oxide (IZO), zinc oxide (ZnO), zinc tin oxide (ZTO), or indium gallium zinc oxide (IGZO).

The protective layer PL covers the semiconductor layer SJL. The protective layer PL may perform a function of protecting the semiconductor layer SJL from moisture or foreign matter. The protective layer PL may include a first insulating layer PL1 and a second insulating layer PL2. The first insulating layer PL1 may cover the semiconductor layer SJL and may include first openings PL_OP1 that expose the second electrode layer EL2. The first insulating layer PL1 may surround the sidewall of each of the light emitting members LE_S. For example, the first insulating layer PL1 may be disposed on the sidewall of each of the light emitting members LE_S, and an upper surface of the base semiconductor layer B_SL of the semiconductor layer SJL disposed between the plurality of light emitting members LE_S.

The second insulating layer PL2 may be disposed on the first insulating layer PL1. The second insulating layer PL2 may include second openings PL_OP2 formed to correspond to (or overlapping) the first openings PL_OP1. Each of the first and second insulating layers PL1 and PL2 may include a single layer or multiple layers. For example, each of the first and second insulating layers PL1 and PL2 may include at least one of silicon oxide, silicon nitride, silicon oxy nitride, aluminium oxide, zirconium oxide, hafnium oxide, and titanium oxide.

The areas where the first and second openings PL_OP1 and PL_OP2 are provided may be light emitting areas of the light emitting diode LED. The areas between the light emitting members LE_S may be defined as non-light emitting areas. The height in the light emitting areas of the light emitting diode LED may be different from the height in the non-light emitting areas of the light emitting diode LED.

In FIG. 6A, the second insulating layer PL2 may be disposed along the first insulating layer PL1 and may not have a function of flattening the surface of the light emitting diode LED. For example, the spaces between the light emitting members LE_S may not be filled with the second insulating layer PL2. However, as illustrated in FIG. 6B, the protective layer PL may include a second insulating layer PL2a having a flattening function. The second insulating layer PL2a may fill the separation spaces between the light emitting members LE_S to flatten the surface of the light emitting diode LED. For example, the height in the light emitting areas of the light emitting diode LED may be smaller than the height in the non-light emitting areas of the light emitting diode LED.

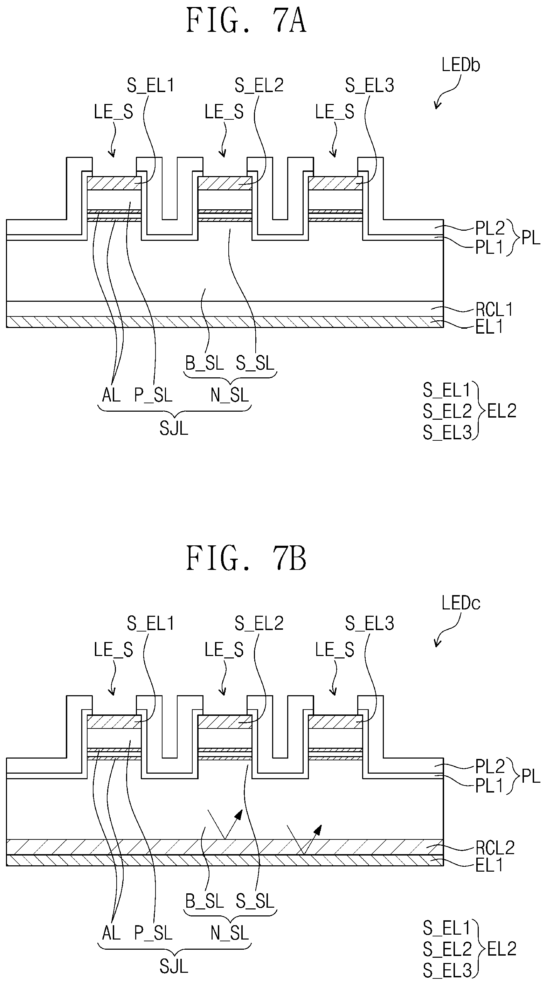

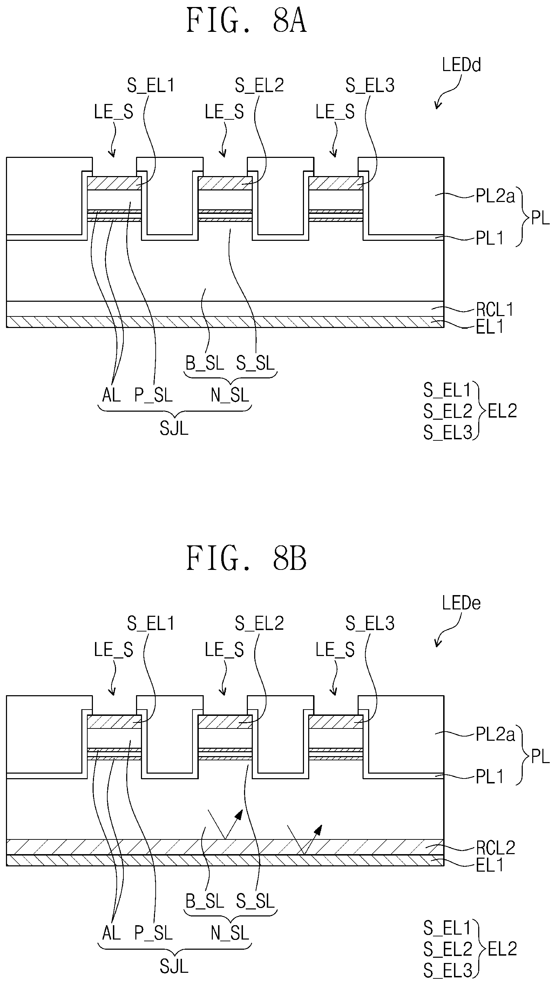

FIGS. 7A and 7B are schematic cross-sectional views of light emitting diodes according to embodiments. FIGS. 8A and 8B are schematic cross-sectional views of light emitting diodes according to embodiments.

Referring to FIGS. 7A and 8A, each of the light emitting diodes LEDb and LEDd may further include a first optical control layer RCL1 disposed between the first electrode layer EL1 and the base semiconductor layer B_SL.

The first optical control layer RCL1 may include a reflective material, and the reflective material may include nickel (Ni).

Referring to FIGS. 7B and 8B, each of the light emitting diodes LEDc and LEDe may further include a second optical control layer RCL2 disposed between the first electrode layer EL1 and the base semiconductor layer B_SL.

The second optical control layer RCL2 may include a transparent conductive material. The transparent conductive material may include transparent conductive oxide such as indium tin oxide (ITO), indium zinc oxide (IZO), zinc oxide (ZnO), zinc tin oxide (ZTO), or indium gallium zinc oxide (IGZO).

The second optical control layer RCL2 may have a refractive index different from those of the first semiconductor layer N_SL and the first electrode layer EL1. In an embodiment, the second optical control layer RCL2 may have a lower refractive index than the first semiconductor layer N_SL. Due to the difference in refractive index between the first semiconductor layer N_SL and the second optical control layer RCL2 and the difference in refractive index between the first electrode layer EL1 and the second optical control layer RCL2, interfacial reflection may occur between the layers. For example, a condition in which total reflection occurs in the first electrode layer EL1 may be satisfied, and thus the light emission efficiency of the light emitting diodes LEDc and LEDe may be improved.

In FIGS. 7A and 8A, each of the light emitting diodes LEDb and LEDd may further include a third optical control layer disposed under the first electrode layer EL1. The third optical control layer and the first optical control layer RCL1 may include the same reflective material.

In FIGS. 7B and 8B, each of the light emitting diodes LEDc and LEDe may further include a fourth optical control layer disposed under the first electrode layer EL1. The fourth optical control layer and the second optical control layer RCL2 may include the same transparent conductive material.

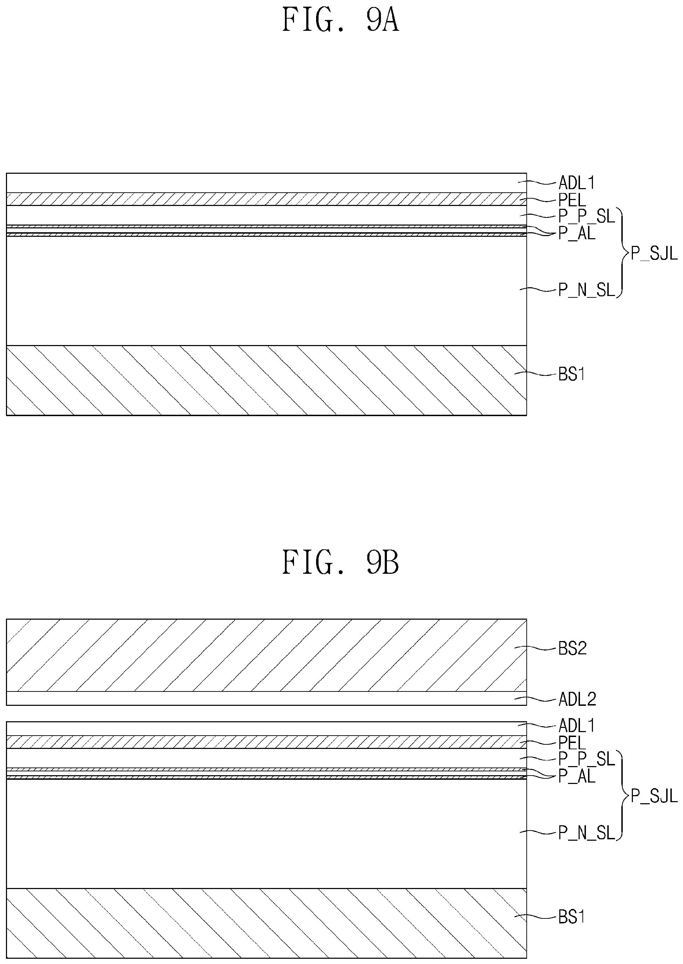

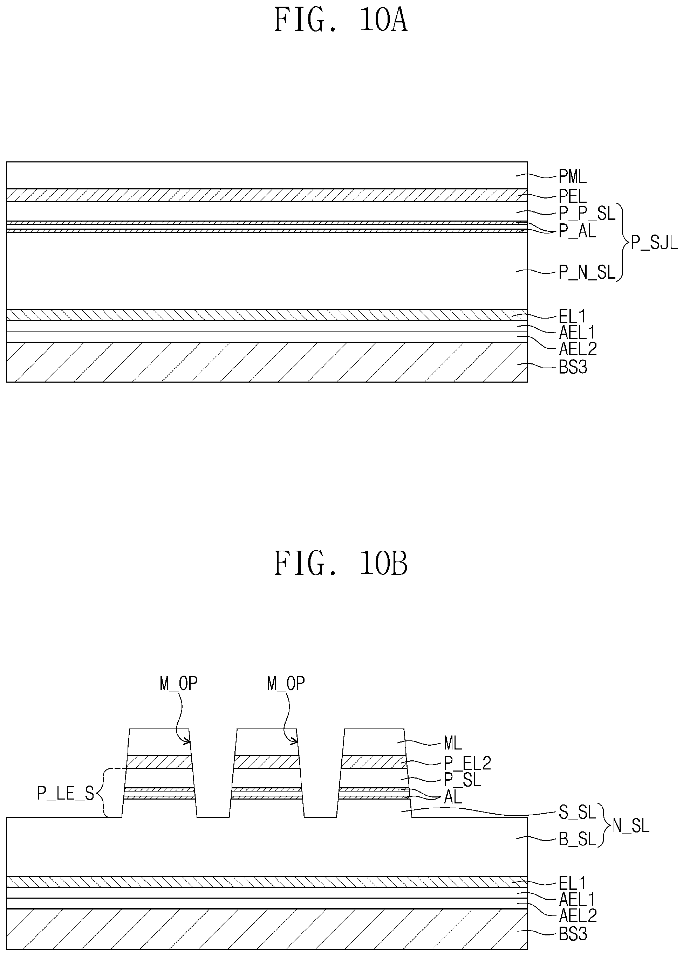

FIGS. 9A to 9H are process views illustrating a process of manufacturing the light emitting diode LED according to an embodiment. FIGS. 10A to 10H are process views illustrating a process of manufacturing the light emitting diode LED according to an embodiment.

Referring to FIG. 9A, a preliminary semiconductor layer P_SJL may be formed on a first base substrate BS1. The first base substrate BS1 may be a silicon substrate. The preliminary semiconductor layer P_SJL may include a first preliminary semiconductor layer P_N_SL, a preliminary active layer P_AL, and a second preliminary semiconductor layer P_P_SL. The preliminary active layer P_AL may be disposed between the first preliminary semiconductor layer P_N_SL and the second preliminary semiconductor layer P_P_SL. The first preliminary semiconductor layer P_N_SL may include an N-type semiconductor layer, and the second preliminary semiconductor layer P_P_SL may include a P-type semiconductor layer.

A transparent conductive film PEL may be formed on the preliminary semiconductor layer P_SJL through a deposition process, and the type of deposition process is not limited. In an embodiment, the transparent conductive film PEL may be disposed on the second preliminary semiconductor layer P_P_SL. The transparent conductive film PEL may include transparent conductive oxide such as indium tin oxide (ITO), indium zinc oxide (IZO), zinc oxide (ZnO), zinc tin oxide (ZTO), or indium gallium zinc oxide (IGZO).

A first adhesive insulating layer ADL1 may be disposed on the transparent conductive film PEL through a deposition process. The first adhesive insulating layer ADL1 may include at least one of silicon oxide, silicon nitride, and silicon oxy nitride.

Referring to FIG. 9B, a second base substrate BS2 may be disposed over the first adhesive insulating layer ADL1. A second adhesive insulating layer ADL2 may be disposed on the lower surface of the second base substrate BS2 to face the first adhesive insulating layer ADL1. The second adhesive insulating layer ADL2 and the first adhesive insulating layer ADL1 may include the same material. The first and second base substrates BS1 and BS2 may be coupled with each other by attaching the second adhesive insulating layer ADL2 to the first adhesive insulating layer ADL1.

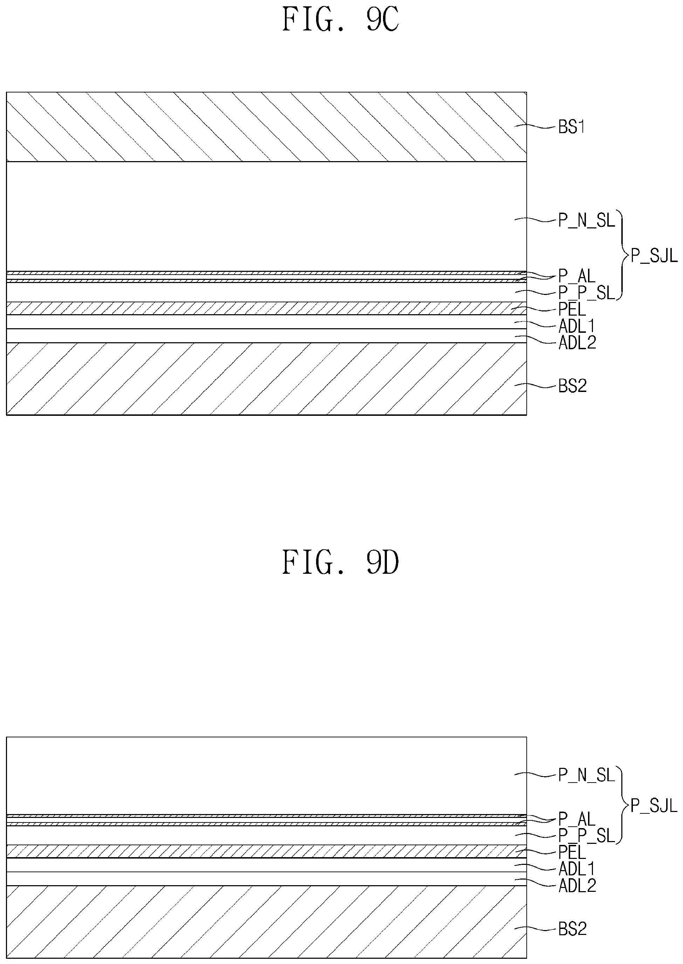

Thereafter, in the case that an upside-down process is performed, the second base substrate BS2 may be disposed under the first base substrate BS1 as illustrated in FIG. 9C.

Referring to FIGS. 9C and 9D, the first base substrate BS1 may be removed through a grinding process. After the grinding process, a portion of the preliminary semiconductor layer P_SJL (e.g., a portion of the first preliminary semiconductor layer P_N_SL) may be removed through an etching process.

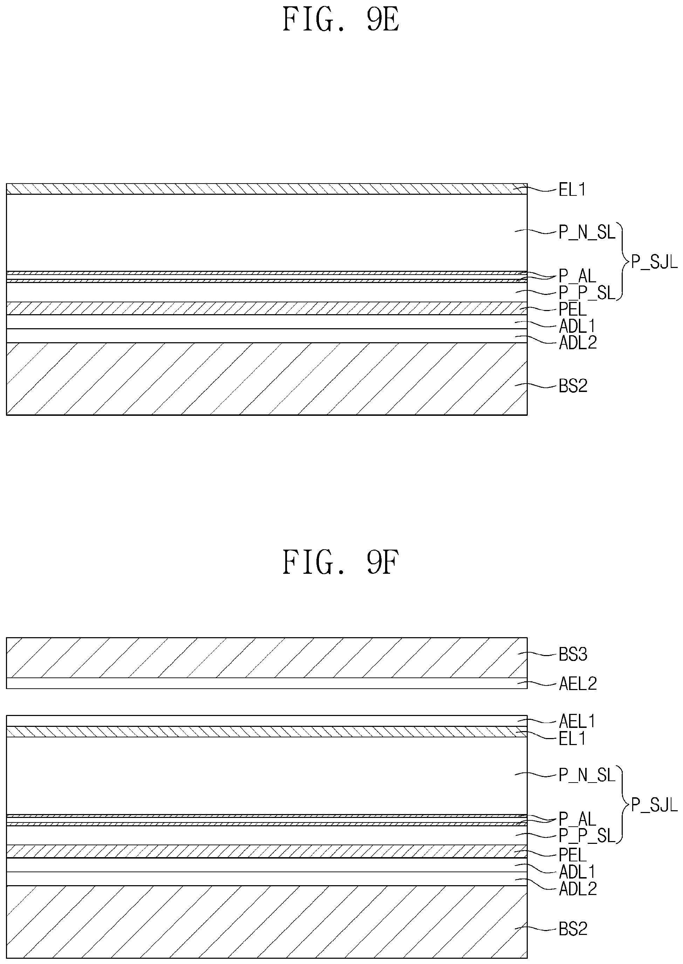

Referring to FIG. 9E, the first electrode layer EL1 may be formed on the first preliminary semiconductor layer P_N_SL. The first electrode layer EL1 may include a high-reflective material having a relatively high reflectance. For example, the high-reflective material may include at least one of silver (Ag), aluminium (Al), gold (Au), chromium (Cr), a distributed Bragg reflective material, and barium sulfate (BaSO₄).

Referring to FIG. 9F, a first adhesive conductive layer AEL1 may be formed on the first electrode layer EL1. The first adhesive conductive layer AEL1 may include titanium (Ti) or gold (Au). A third base substrate BS3 may be disposed over the first adhesive conductive layer AEL1. A second adhesive conductive layer AEL2 may be disposed on the lower surface of the third base substrate BS3 to face the first adhesive conductive layer AEL1. The second adhesive conductive layer AEL2 and the first adhesive conductive layer AEL1 may include the same material. The second adhesive conductive layer AEL2 may be attached to the first adhesive conductive layer AEL1 by a high-temperature and high-pressure process. The second and third base substrates BS2 and BS3 may be coupled with each other by attaching the second adhesive conductive layer AEL2 to the first adhesive conductive layer AEL1.

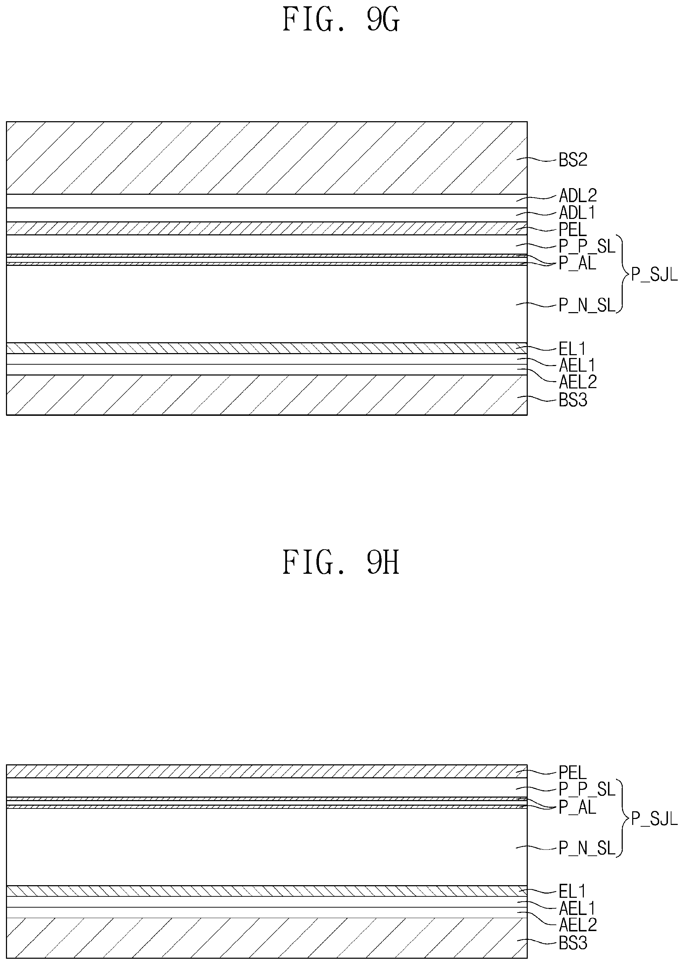

Thereafter, in the case that an upside-down process is performed, the third base substrate BS3 may be disposed under the second base substrate BS2 as illustrated in FIG. 9G.

Referring to FIGS. 9G and 9H, the second base substrate BS2 may be removed through a grinding process. After the grinding process, the first and second adhesive insulating layers ADL1 and ADL2 may be removed through an etching process, and the transparent conductive film PEL may be exposed.

Referring to FIG. 10A, a preliminary mask layer PML may be disposed on the transparent conductive film PEL. The preliminary mask layer PML may include at least one of silicon oxide, silicon nitride, and silicon oxy nitride.

Referring to FIGS. 10A and 10B, a mask layer ML having an opening pattern M_OP in a partial area of the mask layer ML may be formed by making the preliminary mask layer PML, which is patterned. A preliminary second electrode layer P_EL2 and a preliminary light emitting member P_LE_S may be formed by making the transparent conductive film PEL and the preliminary semiconductor layer P_SJL, which is patterned using the mask layer ML. For example, the patterned preliminary semiconductor layer P_SJL may include preliminary light emitting members P_LE_S, and the sidewall of each of the preliminary light emitting members P_LE_S may have an inclined structure.

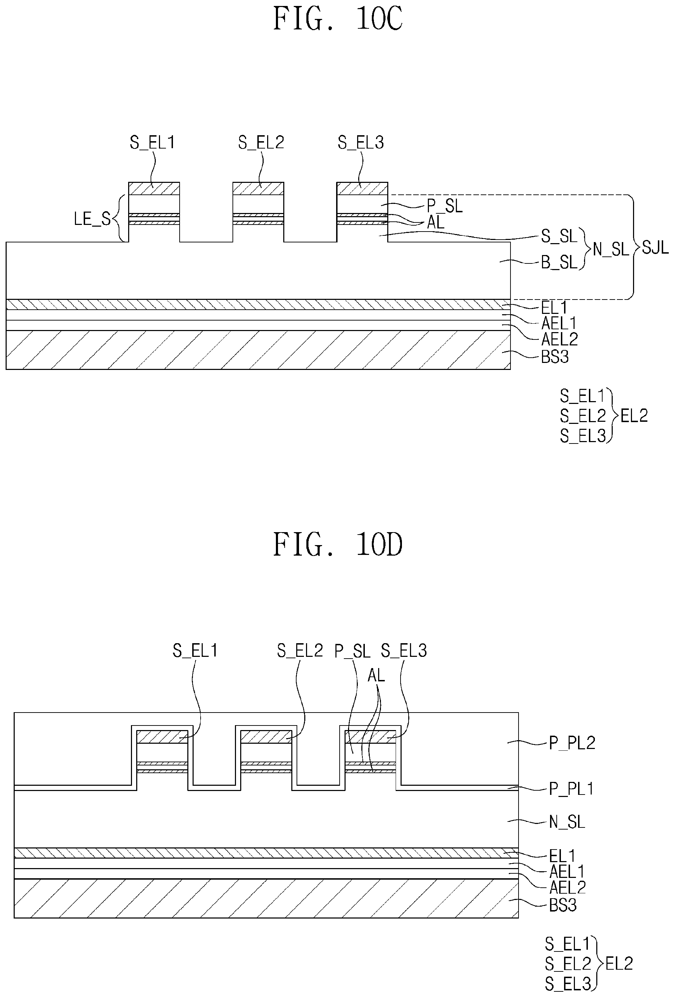

Referring to FIG. 10C, the light emitting members LE_S having a vertical sidewall structure may be formed by etching the preliminary second electrode layer P_EL2 and the preliminary light emitting members P_LE_S through an etching process. For example, the sub-electrodes S_EL1, S_EL2, and S_EL3 may be disposed on the light emitting members LE_S, respectively.

Each of the light emitting members LE_S may be defined by the sub-semiconductor layer S_SL, the active layer AL, and the second semiconductor layer P_SL. For example, the sub-electrodes S_EL1, S_EL2, and S_EL3 may be disposed on the second semiconductor layers P_SL, respectively.

In an embodiment, the etching process illustrated in FIG. 10C may be omitted. For example, each of the light emitting members LE_S may have an inclined sidewall structure.

Referring to FIGS. 10C and 10D, a first preliminary insulating layer P_PL1 may be formed on the semiconductor layer SJL and the second electrode layer EL2, and a second preliminary insulating layer P_PL2 may be formed on the first preliminary insulating layer P _PL1.

Each of the first and second preliminary insulating layers P_PL1 and P_PL2 may include at least one of silicon oxide, silicon nitride, silicon oxy nitride, and aluminum oxide.

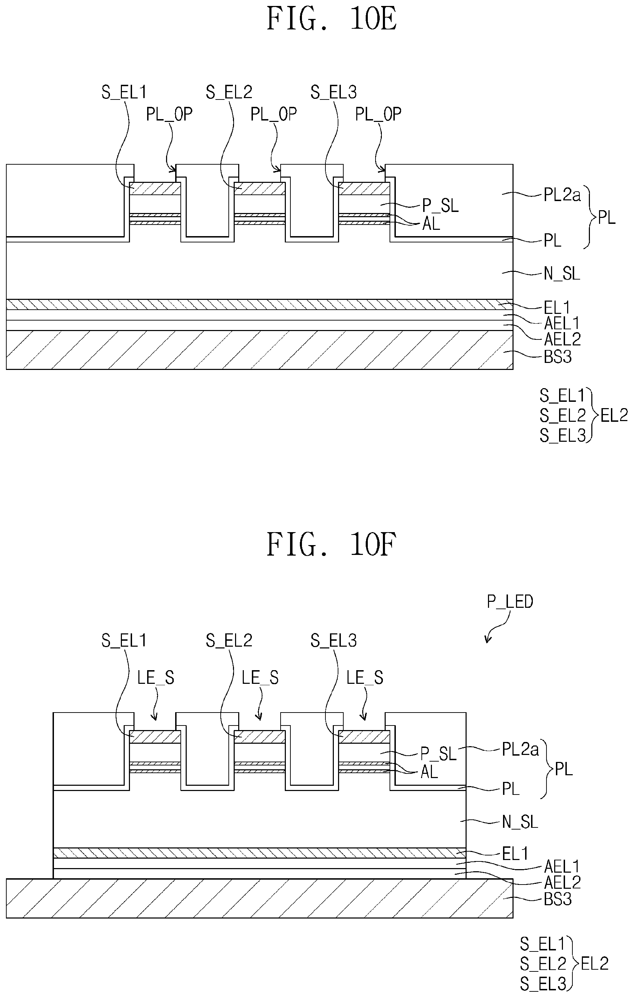

Referring to FIGS. 10D and 10E, the protective layer PL including the first and second insulating layers PL1 and PL2a may be formed by making the first and second preliminary insulating layers P_PL1 and P_PL2, which are patterned through a photolithography process. Openings PL_OP exposing the second electrode layer EL2 may be formed in the protective layer PL. The openings PL_OP may correspond to the sub-electrodes S_EL1 to S_EL3, respectively. Each of the openings PL_OP may include the first and second openings PL_OP1 and PL_OP2 illustrated in FIG. 6A.

Referring to FIG. 10F, preliminary light emitting diodes P_LED may be formed on the third base substrate BS3 through a cutting process of cutting light emitting diodes to a desired (or selected) size.

Referring to FIGS. 10F and 10G, the light emitting diode LED may be completed by removing the third base substrate BS3 through a grinding process. In the grinding process, the first and second adhesive conductive layers AEL1 and AEL2 may be removed together with the third base substrate BS3. In another example, at least one of the first and second adhesive conductive layers AEL1 and AEL2 may remain without being removed in the grinding process.

Referring to FIG. 10H, the light emitting diode LED may be transferred to the circuit element layer 20 illustrated in FIG. 2. In an embodiment, a first via layer VIA1 may be disposed at the top of the circuit element layer 20. An anode connecting electrode ACE and a cathode connecting electrode CCE may be disposed on the first via layer VIA1. The anode connecting electrode ACE and the cathode connecting electrode CCE may be spaced apart from each other when viewed from above the plane. A contact hole CH for connecting the anode connecting electrode ACE to one transistor included in a pixel circuit may be formed in the first via layer VIA1.

A second via layer VIA2 may be formed on the first via layer VIA1, and the anode connecting electrode ACE and the cathode connecting electrode CCE may be partially covered by the second via layer VIA2. A first via hole VH1 for partially exposing the anode connecting electrode ACE and a second via hole VH2 for partially exposing the cathode connecting electrode CCE may be formed in the second via layer VIA2. The light emitting diode LED may be disposed on the cathode connecting electrode CCE exposed through the second via hole VH2. The first electrode layer EL1 of the light emitting diode LED may be electrically connected to the cathode connecting electrode CCE.

In an embodiment, a bonding electrode AML may be disposed between the cathode connecting electrode CCE and the first electrode layer EL1 of the light emitting diode LED. Accordingly, the first electrode layer EL1 of the light emitting diode LED may be fixed and electrically connected to the cathode connecting electrode CCE by the bonding electrode AML. In an embodiment, the bonding electrode AML may include gold (Au), titanium (Ti), or the like.

In the case that the first and second adhesive conductive layers AEL1 and AEL2 (refer to FIG. 10G) are additionally disposed on the rear surface of the first electrode layer EL1, the coupling force between the first electrode layer EL1 and the cathode connecting electrode CCE may be further improved.

The anode connecting electrode ACE and the second electrode layer EL2 (e.g., S_EL1, S_EL2, and S_EL3) of the light emitting diode LED may be electrically connected through a bridge electrode DCE. The bridge electrode DCE may be connected to the anode connecting electrode ACE through the first via hole VH1 formed in the second via layer VIA2. The bridge electrode DCE may be disposed on the second via layer VIA2 and the second electrode layer EL2 of the light emitting diode LED. In an embodiment, the bridge electrode DCE may include a transparent conductive material. For example, the bridge electrode DCE may include transparent conductive oxide such as indium tin oxide (ITO), indium zinc oxide (IZO), zinc oxide (ZnO), zinc tin oxide (ZTO), or indium gallium zinc oxide (IGZO).

The bank layer BDL may be formed on the second via layer VIA2. The bank layer BDL may include a light emitting opening B_OP for exposing the light emitting diode LED, and a light emitting area EA may be defined by the light emitting opening B_OP. A flattening layer PRL may be formed on the light emitting diode LED exposed through the light emitting opening B_OP. The flattening layer PRL may be formed through an ink-jet process or a coating process and may include an organic material.

A barrier layer BRL may be formed on the flattening layer PRL. The barrier layer BRL may function to protect the light emitting diode LED from moisture or foreign matter. The barrier layer BRL may have a single-layer structure or a multi-layer structure. In an embodiment, the barrier layer BRL may include at least one of silicon oxide, silicon nitride, silicon oxy nitride, aluminium oxide, zirconium oxide, hafnium oxide, and titanium oxide. Thereby, respective components from the first via layer VIA1 to the barrier layer BRL as illustrated in FIG. 10H may be defined as the light emitting element layer 30 as illustrated in FIG. 2. For example, in addition to the light emitting diode LED, the light emitting element layer 30 may further include the first via layer VIA1, the cathode connecting electrode CCE, the anode connecting electrode ACE, the second via layer VIA2, the bonding electrode AML, the bridge electrode DCE, the bank layer BDL, the flattening layer PRL and the barrier layer BRL.

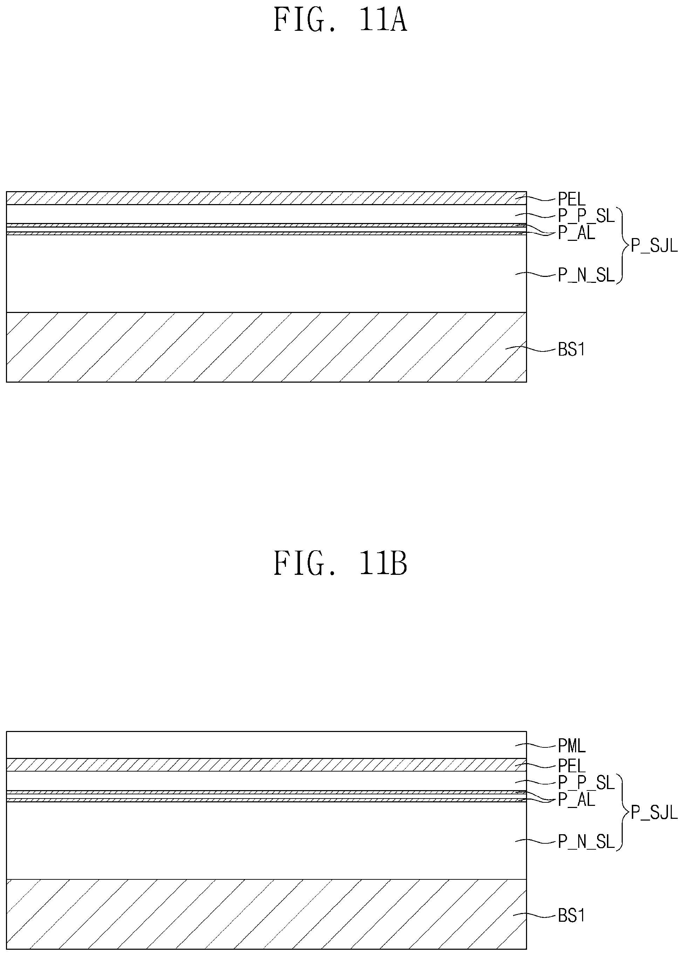

FIGS. 11A to 11J are process views illustrating a process of manufacturing the light emitting diode LED according to an embodiment. Among the components illustrated in FIGS. 11A to 11J, components identical to the components illustrated in FIGS. 9A to 9H and 10A to 10H will be assigned with identical reference numerals, and redundant description thereabout will be omitted for descriptive convenience.

Referring to FIG. 11A, the preliminary semiconductor layer P_SJL may be formed on the first base substrate BS1. The first base substrate BS1 may be a silicon substrate. The preliminary semiconductor layer P_SJL may include the first preliminary semiconductor layer P_N_SL, the preliminary active layer P_AL, and the second preliminary semiconductor layer P_P_SL. The preliminary active layer P_AL may be disposed between the first preliminary semiconductor layer P_N_SL and the second preliminary semiconductor layer P_P_SL. The first preliminary semiconductor layer P_N_SL may include an N-type semiconductor layer, and the second preliminary semiconductor layer P_P_SL may include a P-type semiconductor layer.

The transparent conductive film PEL may be formed on the preliminary semiconductor layer P_SJL. In an embodiment, the transparent conductive film PEL may be disposed on the second preliminary semiconductor layer P _P_SL. The transparent conductive film PEL may include transparent conductive oxide such as indium tin oxide (ITO), indium zinc oxide (IZO), zinc oxide (ZnO), zinc tin oxide (ZTO), or indium gallium zinc oxide (IGZO).

Referring to FIG. 11B, the preliminary mask layer PML may be disposed on the transparent conductive film PEL. The preliminary mask layer PML may include at least one of silicon oxide, silicon nitride, and silicon oxy nitride.

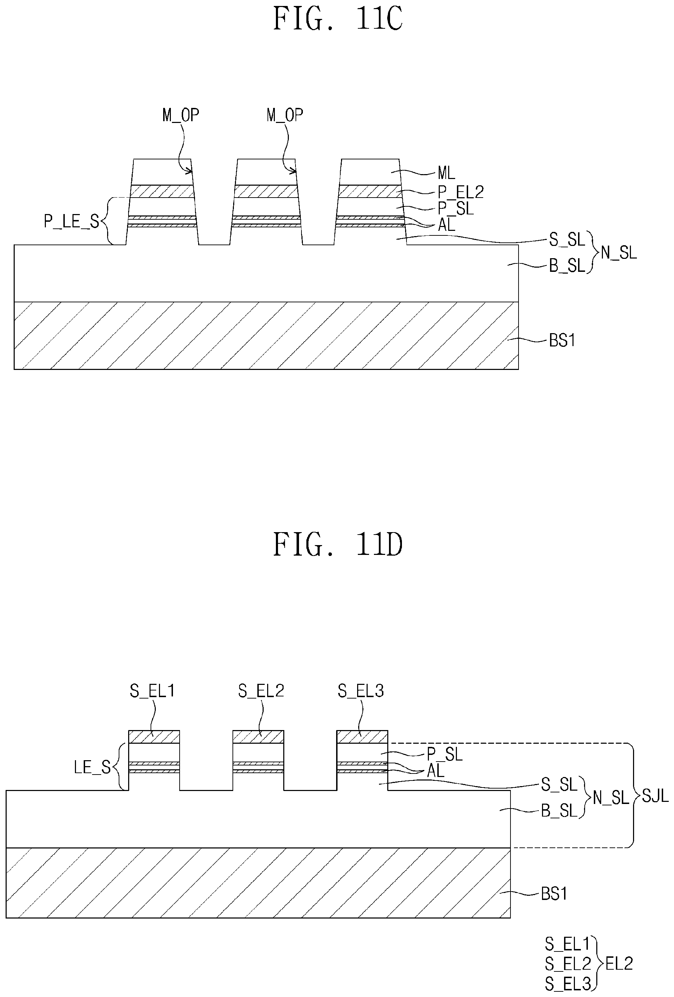

Referring to FIGS. 11B and 11C, the mask layer ML having the opening pattern M_OP in a partial area of the mask layer ML may be formed by making the preliminary mask layer PML, which is patterned. The preliminary second electrode layer P_EL2 and the preliminary light emitting member P_LE_S may be formed by making the transparent conductive film PEL and the preliminary semiconductor layer P_SJL, which is patterned using the mask layer ML. For example, the patterned preliminary semiconductor layer P_SJL may include the preliminary light emitting members P_LE_S, and the sidewall of each of the preliminary light emitting members P_LE_S may have an inclined structure.

Referring to FIG. 11D, the light emitting members LE_S having a vertical sidewall structure may be formed by etching the preliminary second electrode layer P_EL2 and the preliminary light emitting members P_LE_S through an etching process. For example, the sub-electrodes S_EL1, S_EL2, and S_EL3 may be disposed on the light emitting members LE_S, respectively.

Each of the light emitting members LE_S may be defined by the sub-semiconductor layer S_SL, the active layer AL, and the second semiconductor layer P_SL.

In an embodiment, the etching process illustrated in FIG. 11D may be omitted. For example, each of the light emitting members LE_S may have an inclined sidewall structure.

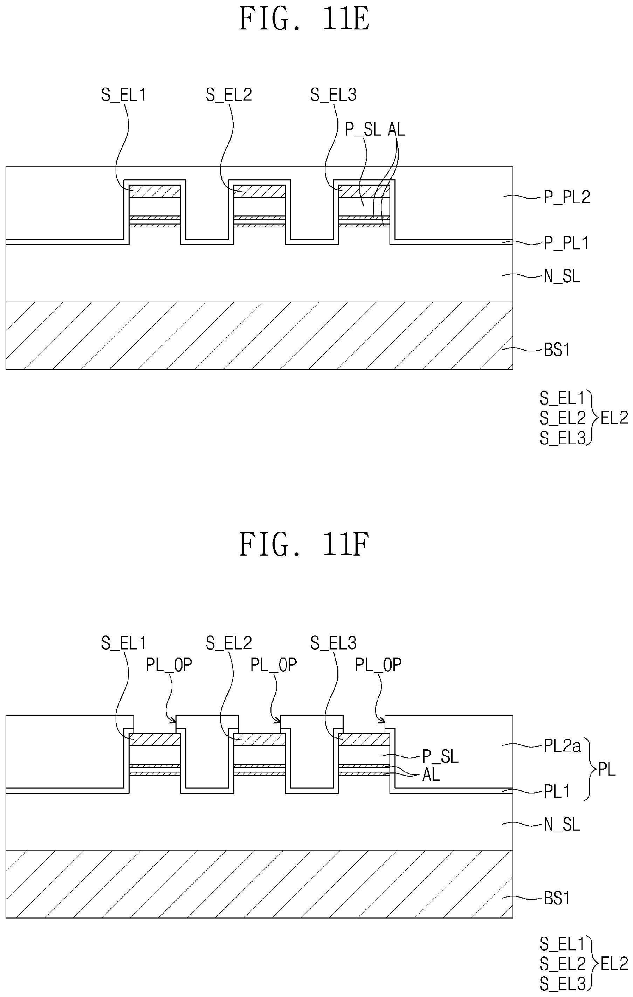

Referring to FIGS. 11D and 11E, the first preliminary insulating layer P_PL1 may be formed on the semiconductor layer SJL and the second electrode layer EL2, and the second preliminary insulating layer P_PL2 may be formed on the first preliminary insulating layer P _PL1.

Each of the first and second preliminary insulating layers P_PL1 and P_PL2 may include at least one of silicon oxide, silicon nitride, silicon oxy nitride, and aluminium oxide.

Referring to FIGS. 11E and 11F, the protective layer PL including the first and second insulating layers PL1 and PL2a may be formed by making the first and second preliminary insulating layers P_PL1 and P_PL2, which are patterned through a photolithography process. The openings PL_OP exposing the second electrode layer EL2 may be formed in the protective layer PL. The openings PL_OP may correspond to the sub-electrodes S_EL1 to S_EL3, respectively. Each of the openings PL_OP may include the first and second openings PL_OP1 and PL_OP2 illustrated in FIG. 6A.

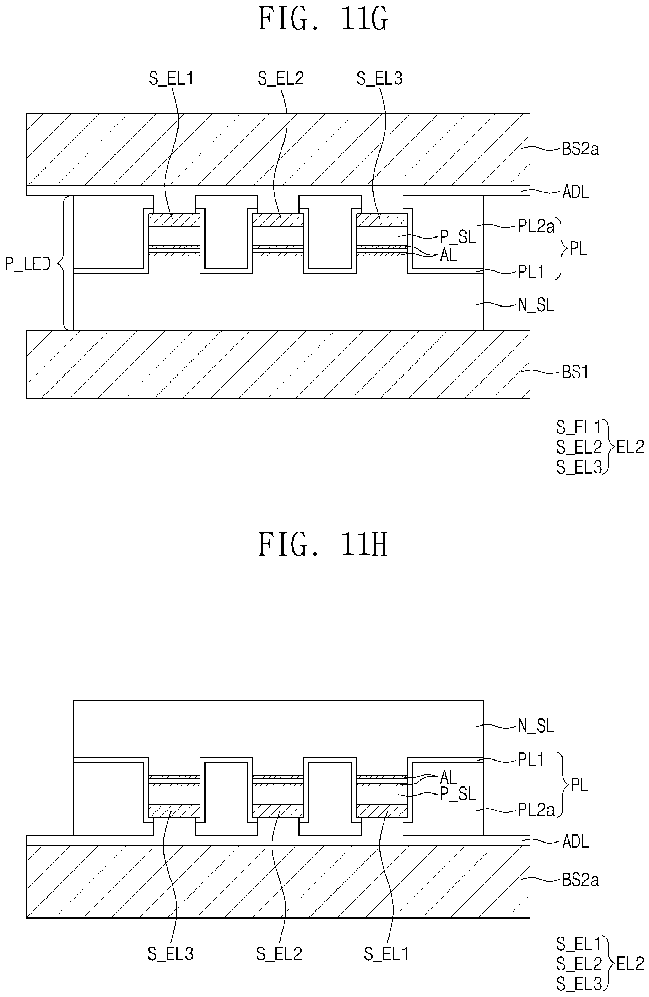

Referring to FIG. 11G, the preliminary light emitting diodes P_LED may be formed on the first base substrate BS1 through a cutting process of cutting light emitting diodes to a desired (or selected) size. A second base substrate BS2a may be disposed on the preliminary light emitting diodes P_LED. The second base substrate BS2a and the preliminary light emitting diodes P_LED may be coupled by an adhesive layer ADL.

Thereafter, in the case that an upside-down process is performed, the second base substrate BS2a may be disposed under the first base substrate BS1.

Referring to FIGS. 11G and 11H, the first base substrate BS1 may be removed through a grinding process.

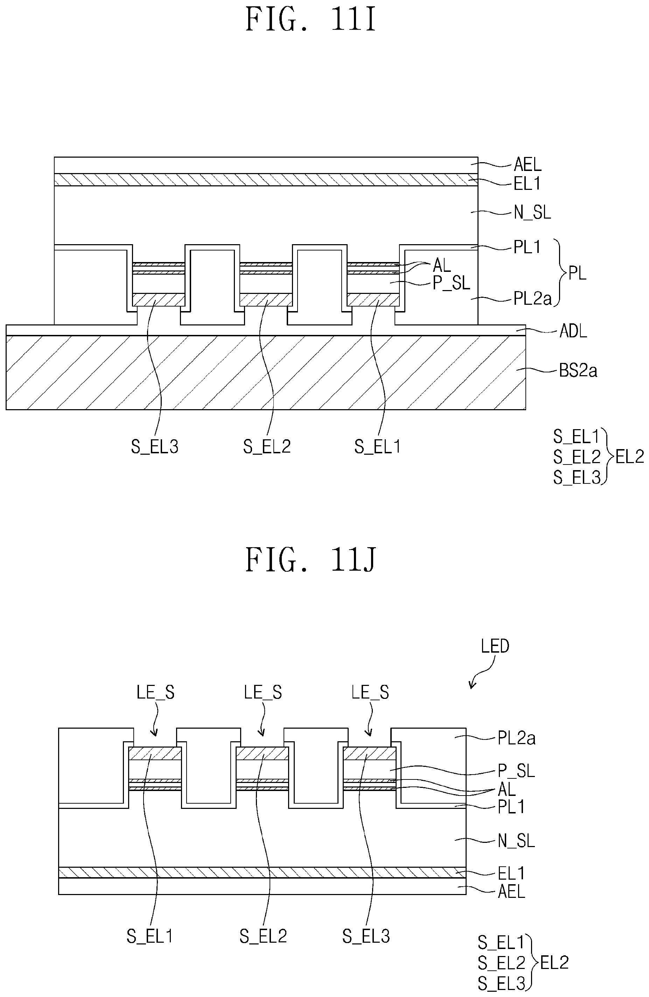

Referring to FIG. 11I, the first electrode layer EL1 may be formed on the semiconductor layer SJL (e.g., the first semiconductor layer N_SL). The first electrode layer EL1 may include a high-reflective material having a relatively high reflectance. For example, the high-reflective material may include silver (Ag), aluminium (Al), titanium (Ti), gold (Au), or copper (Cu). An adhesive conductive layer AEL may be additionally formed on the first electrode layer EL1. The adhesive conductive layer AEL may include titanium (Ti) or gold (Au).

Referring to FIGS. 11I and 11J, the second base substrate BS2a and the adhesive layer ADL may be removed through a grinding process, and thus the light emitting diode LED may be completed.

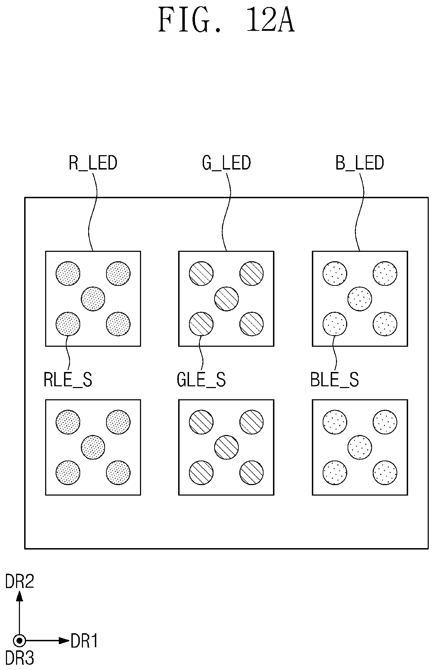

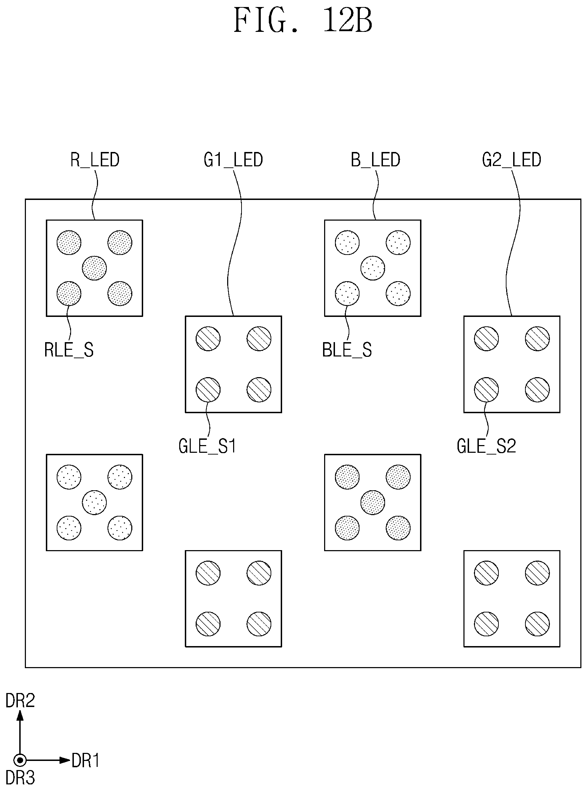

FIG. 12A is a schematic plan view illustrating an arrangement structure of red, green, and blue light emitting diodes according to an embodiment, and FIG. 12B is a schematic plan view illustrating an arrangement structure of red, first green, blue, and second green light emitting diodes according to an embodiment.

Referring to FIG. 12A, light emitting diodes may be disposed in the display area DA of the display device DD. In an embodiment, the light emitting diodes may include the red light emitting diode R_LED that generates the light of the first color (or red light), the green light emitting diode G_LED that generates the light of the second color (or green light), and the blue light emitting diode B_LED that generates the light of the third color (or blue light).

The red light emitting diode R_LED may include red light emitting members RLE_S, the green light emitting diode G_LED may include green light emitting members GLE_S, and the blue light emitting diode B_LED may include blue light emitting members BLE_S. Although FIG. 12A illustrates an example that the light emitting diodes outputting the light of the different colors include the same number of light emitting members, embodiments are not limited thereto. For example, the number of blue light emitting members BLE_S included in the blue light emitting diode B_LED may be different from the number of green light emitting members GLE_S included in the green light emitting diode G_LED.

The red, green, and blue light emitting diodes R_LED, G_LED, and B_LED may be sequentially arranged in the first direction DR1. The red light emitting diodes R_LED may be disposed in the first column parallel to the second direction DR2, the green light emitting diodes G_LED may be disposed in the second column parallel to the second direction DR2, and the blue light emitting diodes B_LED may be disposed in the third column parallel to the second direction DR2.

Although FIG. 12A illustrates the structure in which the light emitting diodes outputting light of the same color are arranged in a stripe form in the second direction DR2, the arrangement structure of the light emitting diodes is not limited thereto.

As illustrated in FIG. 12B, the light emitting diodes may include the red light emitting diode R_LED, the first green light emitting diode G1_LED, the blue light emitting diode B_LED, and the second green light emitting diode G2_LED.

The red light emitting diode R_LED may include red light emitting members RLE_S, and the blue light emitting diode B_LED may include blue light emitting members BLE_S. The first green light emitting diode G1_LED may include first green light emitting members GLE_S1, and the second green light emitting diode G2_LED may include second green light emitting members GLE_S2. The number of blue light emitting members BLE_S included in the blue light emitting diode B_LED (e.g., five) may be different from the number of first green light emitting members GLE_S1 included in the first green light emitting diode G1_LED (e.g., four), and different from the number of second green light emitting members GLE_S2 included in the second green light emitting diode G2_LED (e.g., four).

In the first row, the red and blue light emitting diodes R_LED and B_LED may be alternately arranged in the first direction DR1. In the second row, the first and second green light emitting diodes G1_LED and G2_LED may be alternately arranged in the first direction DR1. In the third row, the blue and red light emitting diodes B_LED and R_LED may be alternately arranged in the first direction DR1. In the fourth row, the second and first green light emitting diodes G2_LED and G1_LED may be alternately arranged in the first direction DR1.

The light emitting diodes employed (or implemented) in the display device DD may be arranged in various forms other than the arrangement structure illustrated in FIGS. 12A and 12B.

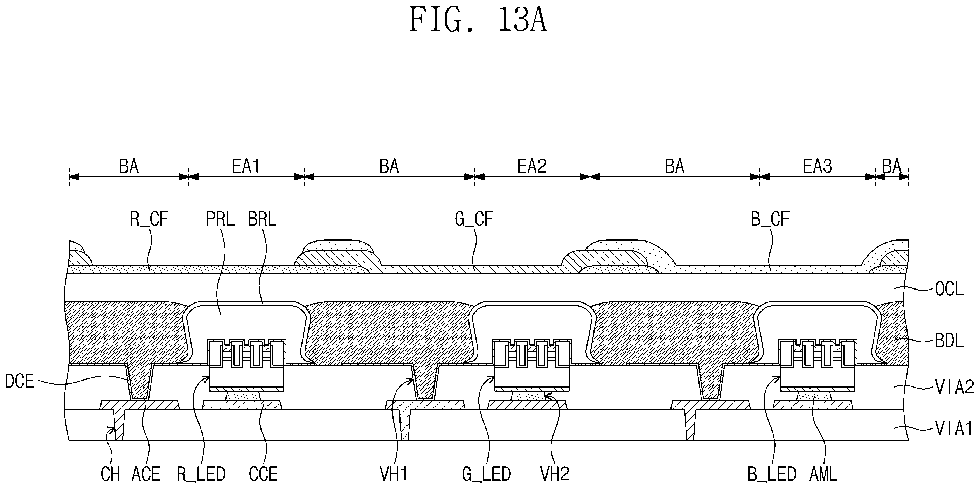

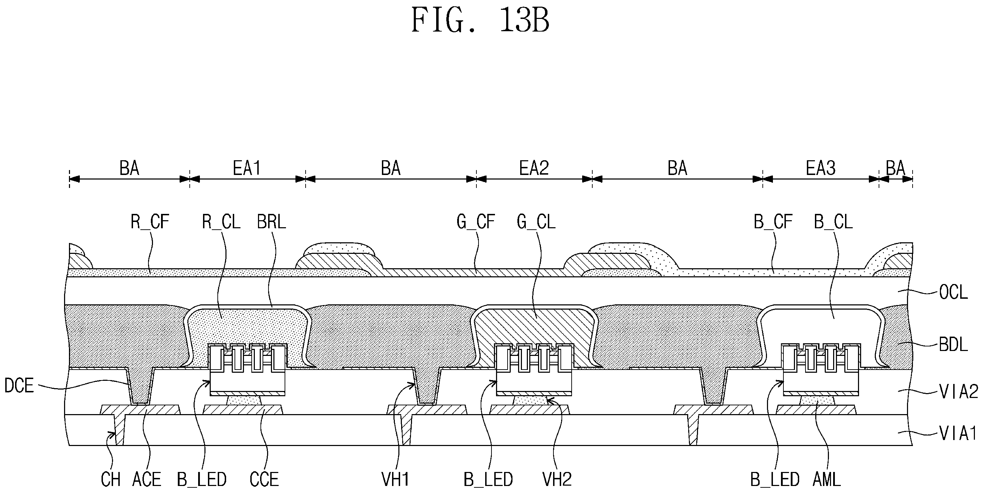

FIGS. 13A and 13B are schematic cross-sectional views of the display device according to embodiments. Among the components illustrated in FIGS. 13A and 13B, components identical to the components illustrated in FIG. 10H will be assigned with identical reference numerals, and redundant description thereabout will be omitted.

Referring to FIG. 13A, the display area DA (refer to FIG. 3) may include a first light emitting area EA1, a second light emitting area EA2, a third light emitting area EA3, and the non-light emitting area BA. The first to third light emitting areas EA1, EA2, and EA3 may output light of different colors. The first light emitting area EA1 may be an area through which red light is output, the second light emitting area EA2 may be an area through which green light is output, and the third light emitting area EA3 may be an area through which blue light is output. For example, the red light emitting diode R_LED may be disposed in the first light emitting area EA1, the green light emitting diode G_LED may be disposed in the second light emitting area EA2, and the blue light emitting diode B_LED may be disposed in the third light emitting area EA3.

An overcoating layer OCL may be disposed on the barrier layer BRL (or the flattening layer PRL) and the bank layer BDL. The overcoating layer OCL may be formed in the entire display area DA and may compensate for the step between the barrier layer BRL and the bank layer BDL to provide a flat surface over the entire display area DA. Respective components from the first via layer VIA1 to the overcoating layer OCL as illustrated in FIG. 13A may be defined as the light emitting element layer 30 as illustrated in FIG.2. For example, in addition to the light emitting diodes R_LED, G_LED and B_LED, the light emitting element layer 30 may further include the first via layer VIA1, the cathode connecting electrode CCE, the anode connecting electrode ACE, the second via layer VIA2, the bonding electrode AML, the bridge electrode DCE, the bank layer BDL, the flattening layer PRL, the barrier layer BRL and the overcoating layer OCL.

A color filter layer may be formed on the overcoating layer OCL. In an embodiment, the color filter layer may include a red color filter R_CF, a green color filter G_CF, and a blue color filter B_CF. The red color filter R_CF may be disposed in the first light emitting area EA1 and may overlap the red light emitting diode R_LED when viewed from above the plane. The green color filter G_CF may be disposed in the second light emitting area EA2 and may overlap the green light emitting diode G_LED when viewed from above the plane. The blue color filter B_CF may be disposed in the third light emitting area EA3 and may overlap the blue light emitting diode B_LED when viewed from above the plane.

As illustrated in FIG. 13B, the display area DA may include the first light emitting area EA1, the second light emitting area EA2, the third light emitting area EA3, and the non-light emitting area BA. Light emitting diodes (e.g., the blue light emitting diodes B_LED) that output light of the same color (e.g., blue light) may be disposed in the first to third light emitting areas EA1, EA2, and EA3.

A color conversion layer may be disposed on the blue light emitting diode B_LED. The color conversion layer may include a first color conversion layer R_CL, a second color conversion layer G_CL, and a third color conversion layer B_CL. The first color conversion layer R_CL may include a first converter disposed in the first light emitting area EA1 to convert blue light into red light. The second color conversion layer G_CL may include a second converter disposed in the second light emitting area EA2 to convert blue light into green light. The first converter may be a red quantum dot that is excited by blue light and that emits red light, and the second converter may be a green quantum dot that is excited by blue light and that emits green light. The third color conversion layer B_CL may not include a converter. The third color conversion layer B_CL may be a layer that transmits blue light. The third color conversion layer B_CL may include titanium dioxide (TiO₂).

The overcoating layer OCL may be disposed on the first to third color conversion layers R_CL, G_CL, and B_CL and the bank layer BDL. The overcoating layer OCL may be formed in the entire display area DA and may compensate for the step differences between the first to third color conversion layers R_CL, G_CL, and B_CL and the bank layer BDL to provide a flat surface over the entire display area DA. Respective components from the first via layer VIA1 to the overcoating layer OCL as illustrated in FIG. 13B may be defined as the light emitting element layer 30 as illustrated in FIG.2. For example, in addition to the light emitting diodes B_LED, the light emitting element layer 30 may further include the first via layer VIA1, the cathode connecting electrode CCE, the anode connecting electrode ACE, the second via layer VIA2, the bonding electrode AML, the bridge electrode DCE, the bank layer BDL, the color conversion layers R_CL, G_CL, and B_CL, the barrier layer BRL and the overcoating layer OCL.

The color filter layer may be formed on the overcoating layer OCL. In an embodiment, the color filter layer may include the red color filter R_CF, the green color filter G_CF, and the blue color filter B_CF. The red color filter R_CF may be disposed in the first light emitting area EA1, the green color filter G_CF may be disposed in the second light emitting area EA2, and the blue color filter B_CF may be disposed in the third light emitting area EA3.

The display device DD according to the embodiments may be applied to various electronic devices.

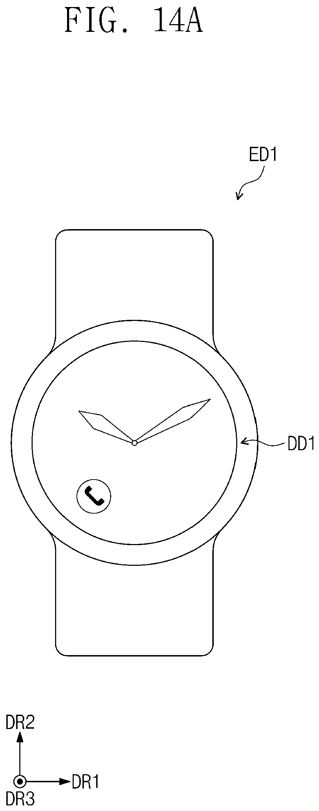

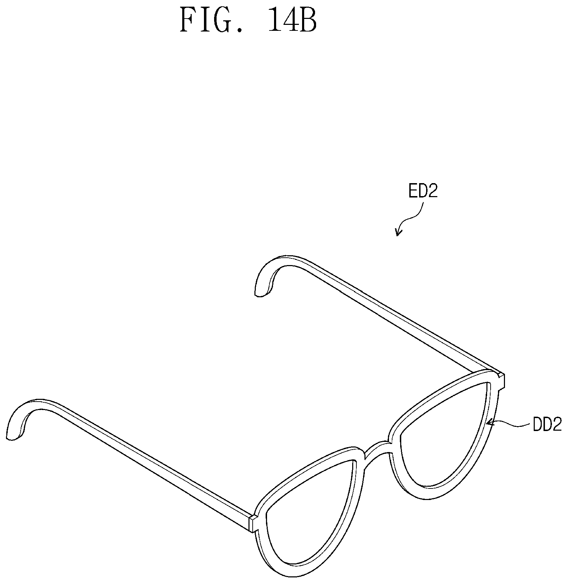

FIG. 14A is a schematic view illustrating a smart watch ED1 including a display device DD1 according to an embodiment, and FIG. 14B is a schematic view illustrating a glasses-type virtual reality device ED2 including a display device DD2 according to an embodiment.

Referring to FIG. 14A, the electronic device such as the smart watch ED1 may employ (or form) the display device DD1 and a frame accommodating the display device DD1, and the display device DD1 may have the structure illustrated in FIGS. 1 to 13B.

Referring to FIG. 14B, the electronic device such as the virtual reality device ED2 may include a left eye lens, a right eye lens, and a frame. Each of the left eye lens and the right eye lens may employ (or form) the display device DD2 and be accommodated in (or fixed to) the frame, and the display device DD2 may have the structure illustrated in FIGS. 1 to 13B.

For example, the electronic device may include at least one of televisions, notebook computers, monitors, advertisement boards, Internet of things (IoTs) device, portable electronic apparatuses including mobile phones, smartphones, tablet personal computers (PCs), mobile communication terminals, electronic organizers, electronic books, portable multimedia players (PMPs), navigations, ultra-mobile personal computers (UMPCs), smartwatches, watchphones, glasses-type displays, head-mounted displays (HMDs), instrument panels for automobiles, center fascias for automobiles, or center information displays (CIDs) on a dashboard, room mirror displays of automobiles, and displays of an entertainment system on a backside of front seats in automobiles.

According to an embodiment, the light emitting diode may include the light emitting members. For example, the density of driving current may be increased. Accordingly, the driving performance of the light emitting diode may be improved without an increase in voltage.

For example, the first electrode layer of the light emitting diode may include the high-reflective material. Accordingly, the light emission efficiency of the light emitting diode may be improved.

In concluding the detailed description, those skilled in the art will appreciate that many variations and modifications may be made to the embodiments without substantially departing from the principles and scope of the disclosure. Therefore, the disclosed embodiments are used in a generic and descriptive sense only and not for purposes of limitation.

Embodiments are set out in the following clauses:
Clause 1. A method for manufacturing a light emitting diode, the method comprising:
   forming a first electrode layer including a reflective material;
   forming a semiconductor layer including a plurality of light emitting structures spaced apart from one another;
   forming a second electrode layer including a plurality of sub-electrodes disposed on the plurality of light emitting structures, respectively; and
   forming a protective layer configured to cover the semiconductor layer,
   wherein the semiconductor layer includes:
      a first semiconductor layer including a base semiconductor layer disposed on the first electrode layer and a plurality of sub-semiconductor layers configured to protrude from the base semiconductor layer;
      a plurality of active layers disposed on the plurality of sub-semiconductor layers, respectively; and
      a plurality of second semiconductor layers disposed on the plurality of active layers, respectively, and
      wherein the plurality of sub-electrodes are disposed on the plurality of second semiconductor layers, respectively.
Clause 2. The method of clause 1, wherein the forming of the first electrode layer precedes the forming of the semiconductor layer, and
   wherein the forming of the semiconductor layer is performed on the first electrode layer.
Clause 3. The method of clause 1 or clause 2, wherein the forming of the first electrode layer follows the forming of the semiconductor layer, and
   wherein the forming of the first electrode layer includes forming the first electrode layer on the first semiconductor layer.

## Claims

1. A light emitting diode comprising:
a first electrode layer including a reflective material;
a semiconductor layer disposed on the first electrode layer, the semiconductor layer including a plurality of light emitting members spaced apart from each other;
a second electrode layer including a plurality of sub-electrodes disposed on the plurality of light emitting members, respectively; and
a protective layer covering the semiconductor layer, wherein
the semiconductor layer includes:
a first semiconductor layer including a base semiconductor layer disposed on the first electrode layer and a plurality of sub-semiconductor layers protruding from the base semiconductor layer;
a plurality of active layers disposed on the plurality of sub-semiconductor layers, respectively; and
a plurality of second semiconductor layers disposed on the plurality of active layers, respectively, and
the plurality of sub-electrodes are disposed on the plurality of second semiconductor layers, respectively.

2. The light emitting diode of claim 1, wherein
the base semiconductor layer is directly disposed on the first electrode layer, and
the base semiconductor layer and the plurality of sub-semiconductor layers have a single body shape.

3. The light emitting diode of claim 2, wherein
the first semiconductor layer is an N-type semiconductor layer, and
each of the plurality of second semiconductor layers is a P-type semiconductor layer.

4. The light emitting diode of claim 3, wherein each of the first semiconductor layer and the second semiconductor layers includes at least one of gallium nitride (GaN), indium gallium nitride (InGaN), and aluminium gallium nitride (AlGaN).

5. The light emitting diode of any one of claims 1 to 4, further comprising:
an optical control layer disposed between the first electrode layer and the base semiconductor layer.

6. The light emitting diode of claim 5, wherein the optical control layer includes a reflective material or a transparent conductive material.

7. The light emitting diode of any one of claims 1 to 6, wherein the protective layer includes:
a first insulating layer disposed on sidewalls of the plurality of light emitting members and an upper surface of the base semiconductor layer disposed between the plurality of light emitting members; and
a second insulating layer disposed on the first insulating layer, optionally wherein the second insulating layer fills separation spaces between the plurality of light emitting members.

8. The light emitting diode of any one of claims 1 to 7, wherein the protective layer includes a plurality of openings exposing the plurality of sub-electrodes.

9. The light emitting diode of any one of claims 1 to 8, wherein the reflective material includes at least one of silver (Ag), aluminium (Al), gold (Au), chromium (Cr), a distributed Bragg reflective material, and barium sulfate (BaSO₄).

10. A display device comprising:
a base layer;
a circuit element layer disposed on the base layer; and
a light emitting element layer disposed on the circuit element layer, the light emitting element layer including a light emitting diode, wherein
the light emitting diode includes:
a first electrode layer including a reflective material;
a semiconductor layer disposed on the first electrode layer, the semiconductor layer including a plurality of light emitting members spaced apart from each other;
a second electrode layer including a plurality of sub-electrodes disposed on the plurality of light emitting members, respectively; and
a protective layer covering the semiconductor layer,
the semiconductor layer includes:
a first semiconductor layer including a base semiconductor layer disposed on the first electrode layer and a plurality of sub-semiconductor layers protruding from the base semiconductor layer;
a plurality of active layers disposed on the plurality of sub-semiconductor layers, respectively; and
a plurality of second semiconductor layers disposed on the plurality of active layers, respectively, and
the light emitting element layer includes:
a cathode connecting electrode connected to the first electrode layer, and
an anode connecting electrode connected to the second electrode layer.

11. The display device of claim 10, wherein
the light emitting element layer includes:
a via layer disposed on the circuit element layer, the via layer having first and second via holes partially exposing the anode connecting electrode and the cathode connecting electrode; and
a bridge electrode electrically connected to the anode connecting electrode through the first via hole, the bridge electrode electrically connecting the anode connecting electrode and the second electrode layer, and
the cathode connecting electrode is electrically connected to the first electrode layer through the second via hole, optionally wherein
the light emitting element layer further includes a bonding electrode electrically connected to the cathode connecting electrode through the second via hole, and
the first electrode layer is disposed on the bonding electrode and electrically connected to the cathode connecting electrode through the bonding electrode.

12. The display device of claim 10 or claim 11, wherein the light emitting element layer includes:
(i) a bank layer having a light emitting opening exposing the light emitting diode;
a flattening layer disposed in the light emitting opening to cover the light emitting diode; and
an overcoating layer disposed on the bank layer and the flattening layer; or
(ii) a bank layer having a light emitting opening exposing the light emitting diode;
a color conversion layer disposed in the light emitting opening to convert a color of light output from the light emitting diode; and
an overcoating layer covering the bank layer and the color conversion layer.

13. The display device of any one of claims 10 to 12, wherein:
(i) the display device further comprises a color filter layer disposed on the light emitting element layer, the color filter layer including a color filter; and/or
(ii) the base semiconductor layer is directly disposed on the first electrode layer, and
the base semiconductor layer and the plurality of sub-semiconductor layers have a single body shape.

14. The display device of any one of claims 10 to 13, wherein:
(i) the display device further comprises an optical control layer disposed between the first electrode layer and the base semiconductor layer, wherein the optical control layer includes a reflective material or a transparent conductive material; and/or
(ii) the protective layer includes:
a first insulating layer disposed on sidewalls of the plurality of light emitting members and an upper surface of the base semiconductor layer disposed between the plurality of light emitting members; and
a second insulating layer disposed on the first insulating layer.

15. An electronic device comprising:
a display device; and
a frame accommodating the display device, wherein
the display device includes:
a base layer;
a circuit element layer disposed on the base layer; and
a light emitting element layer disposed on the circuit element layer, the light emitting element layer including a light emitting diode,
the light emitting diode includes:
a first electrode layer including a reflective material;
a semiconductor layer disposed on the first electrode layer, the semiconductor layer including a plurality of light emitting members spaced apart from each other;
a second electrode layer including a plurality of sub-electrodes disposed on the plurality of light emitting members, respectively; and
a protective layer covering the semiconductor layer,
the semiconductor layer includes:
a first semiconductor layer including a base semiconductor layer disposed on the first electrode layer and a plurality of sub-semiconductor layers protruding from the base semiconductor layer;
a plurality of active layers disposed on the plurality of sub-semiconductor layers, respectively; and
a plurality of second semiconductor layers disposed on the plurality of active layers, respectively, and
the light emitting element layer includes a cathode connecting electrode electrically connected to the first electrode layer and an anode connecting electrode electrically connected to the second electrode layer.
